(19) Europäisches Patentamt
European Patent Office
Office européen des brevets

(11) Veröffentlichungsnummer : **0 110 833**
**B1**

(12) **EUROPÄISCHE PATENTSCHRIFT**

(45) Veröffentlichungstag der Patentschrift : **05.03.86**

(51) Int. Cl.⁴ : **G 03 C 5/00**, C 08 G 85/00

(21) Anmeldenummer : **83810542.7**

(22) Anmeldetag : **21.11.83**

(54) **Verwendung von lichtempfindlichen Stoffgemischen für die stromlose Metallabscheidung.**

(30) Priorität : **25.11.82 CH 6871/82**

(43) Veröffentlichungstag der Anmeldung : **13.06.84 Patentblatt 84/24**

(45) Bekanntmachung des Hinweises auf die Patenterteilung : **05.03.86 Patentblatt 86/10**

(84) Benannte Vertragsstaaten : **CH DE FR GB LI NL**

(56) Entgegenhaltungen : **EP-A- 0 033 720**

(73) Patentinhaber : **CIBA-GEIGY AG**
**Klybeckstrasse 141**
**CH-4002 Basel (CH)**

(72) Erfinder : **Finter, Jürgen, Dr.**
**Zasiusstrasse 100**
**D-7800 Freiburg (DE)**
Erfinder : **Fischer, Walter, Dr.**
**Vogesenstrasse 77**
**CH-4153 Reinach (CH)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 110 833 B1

Jouve, 18, rue St-Denis, 75001 Paris, France

**Beschreibung**

Die vorliegende Erfindung betrifft die Verwendung von lichtempfindlichen Stoffgemischen für die stromlose Metallabscheidung, womit sich Abbildungen, besonders elektrisch leitende Ueberzüge und Muster, herstellen lassen.

Elektrisch leitende Ueberzüge und Muster, vor allem für gedruckte Schaltungen, können unter anderem dadurch hergestellt werden, dass man auf nicht-leitenden anorganischen oder organischen Substraten für die stromlose Metallabscheidung geeignete nullwertige Metallkeime erzeugt. Nach dem sogenannten Photoformation-Verfahren kann dies dadurch erfolgen, dass man auf dem Substrat, gegebenenfalls in saurem Medium und in Gegenwart von Halogenidionen, Metallsalze, besonders Salze nicht-edler Metalle, wie Kupferformiat, abscheidet und anschliessend durch Bestrahlung, gegebenenfalls in Gegenwart chemischer Reduktionsmittel, zu nullwertigen Metallkeimen reduziert. Für die Reduktion der Metallsalze werden im allgemeinen lichtempfindliche Reduktionsmittel, ein zweites Reduktionsmittel und ein oberflächenaktives Mittel eingesetzt. Als lichtempfindliche Reduktionsmittel können u. a. Anthrachinondisulfonsäuren und Salze davon, gegebenenfalls im Gemisch mit Metallaktivatoren, wie Zinnsalzen, eingesetzt werden. Dabei müssen die Substrate im allgemeinen vor der Metallabscheidung angeätzt oder mit einer ätzbaren Haftvermittlerschicht versehen werden [intramolekulare photoreduktive Methode ; vgl. z. B. US Patentschriften 3.959.547 und 3.993.802].

Gemäss einem weiteren vorbekannten Verfahren wird auf dem nichtleitenden Substrat eine Titandioxid enthaltende lichtempfindliche Schicht erzeugt oder Titandioxid wird in das Substrat eingearbeitet. Anschliessend muss das das Titandioxid enthaltende Substrat bzw. die das Titandioxid enthaltende Schicht angeätzt werden, um die $TiO_2$-Teilchen für die weitere Behandlung zugänglich zu machen. Das angeätzte Material wird dann mit einer Lösung des gewünschten Metallsalzes behandelt und bestrahlt (Photoelektronen-Methode). Schliesslich können nullwertige Metallkeime auch dadurch erhalten werden, dass man auf dem nicht-leitenden Substrat zuerst ein lichtempfindliches Metallsalz, wie Zinn(II) hydroxid oder Eisenoxalat, abscheidet, durch Bestrahlung ein latentes Bild bzw. reduzierende Metallionen erzeugt und darauf durch Reduktion eines Metallsalzes, im allgemeinen eines Edelmetallsalzes, die nullwertigen Metallkeime erzeugt (photoelektrochemische Methode). Die so erhaltenen nullwertigen Metallkeime können anschliessend in an sich bekannter Weise durch stromlose Metallabscheidung metallisiert und die leitenden Bildstellen gegebenenfalls durch elektrolytische Metallabscheidung weiter verstärkt werden.

Ferner ist bekannt, dass Arylketone, wie Benzophenone oder Thioxanthone, bei aktinischer Bestrahlung in Anwesenheit von H-Donoren, wie Hydroxyl- oder Alkylaminogruppen, zu Arylketylradikalen reduziert werden. Diese reduzierte Form kann ihrerseits andere Verbindungen, wie z. B. Metallsalze, reduzieren. Ueberraschenderweise wurde nun gefunden, dass im Polymerfilm gelöste, so reduzierte Salze von Metallen der Gruppen Ib und VIII des Periodischen Systems, vor allem Palladium- und Kupfersalze, für die stromlose Metallabscheidung geeignet sind und gut haftende metallische Ueberzüge oder Muster ergeben.

Gegenstand der Erfindung ist somit die Verwendung von lichtempfindlichen Stoffgemischen für die stromlose Metallabscheidung, womit sich auf einfache Weise Abbildungen, besonders gut haftende, elektrisch leitende Ueberzüge und Muster erzeugen lassen. Die erfindungsgemäss zu verwendenden Stoffgemische enthalten

a) 0,1 bis 20 Gewichtsprozent einer Verbindung der Formel I

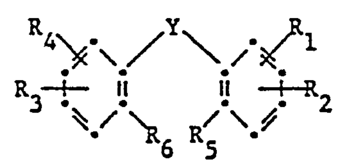

(I)

worin

$R_1$, $R_2$, $R_3$ und $R_4$ unabhängig voneinander ein Wasserstoff- oder Halogenatom, $C_{1-20}$-Alkyl, $—OR_7$, $—N(R_7)_2$, $—SR_7'$, $—NO_2$, $—SO_2R_7'$, $—COR_7$, $—COOR_7$, $—CON(R_7)_2$, $C_{1-4}$-Halogenalkyl, $C_{1-4}$-Hydroxyalkyl, $—O—C_dH_{2d}—COOH$, $—O[CH_2CH(X)O]_n—X$,

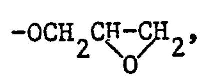

$—OCO—C(X)=CH_2$, $—CO—O[CH_2CH(X)O]_n—X$,

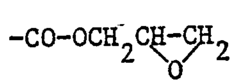

oder $—N(R_7)$ $(CO—C(X)=CH_2)$ oder $R_1$ und $R_2$ und/oder $R_3$ und $R_4$ zusammen —CO—O—CO— oder $—CO—N(R_7)—CO—$,

$R_5$ und $R_6$ je Wasserstoff oder zusammen die direkte Bindung, $—CH_2—$, $—CH_2CH_2—$, —CH=CH—, —S—, —O—, —CO— oder —NH— und

$R_7$ Wasserstoff, $C_{1-20}$-Alkyl, $C_{1-6}$-Hydroxyalkyl, Allyl, Propargyl, $—C_dH_{2d}—OCO—C(X)=CH_2$, Phenyl, Alkylphenyl mit 1-4 C-Atomen im Alkyl, Benzyl, Phenyläthyl oder Cyclohexyl bedeuten,

$R_7'$ dieselbe Bedeutung wie $R_7$ hat, aber ungleich Wasserstoff ist,

n eine Zahl von 1-50, d eine Zahl von 1-4,

X Wasserstoff oder Methyl und

Y —CO— oder —CO—CO— darstellen,

b) 70 bis 99,8 Gewichtsprozent eines Polymeren mit H-Donorgruppen und einem durchschnittlichen Molekulargewicht von mindestens 2 000 Dalton oder eines Polymergemisches, das aus mindestens einer Polymerkomponente mit H-Donorgruppen und einem durchschnittlichen Molekulargewicht von mindestens 2 000 Dalton und mindestens einer zweiten Polymerkomponente mit einem durchschnittlichen Molekulargewicht von mindestens 2 000 Dalton besteht, und

c) 0,1 bis 10 Gewichtsprozent eines oder mehrerer Salze eines Metalls der Gruppe Ib oder VIII des Periodischen Systems, wobei sich die Gewichtsprozente auf die Summe von a + b + c beziehen und sich die Komponenten a, b und c zusammen auf 100 Gewichtsprozent ergänzen und das Polymer b) teilweise mit den Metallsalzen c) komplexiert sein kann.

Stellen $R_1$, $R_2$, $R_3$, $R_4$, $R_7$ oder $R_7'$ Alkylgruppen mit 1-20 C-Atomen dar, so kann es sich dabei um geradkettige oder verzweigte Gruppen handeln, wie z. B. Methyl, Aethyl, n-Propyl, Isopropyl, n-Butyl, sek.-Butyl, tert.-Butyl, n-Pentyl, 2- oder 3-Pentyl, n-Hexyl, 2-Aethylhexyl, n-Heptyl, 2- oder 3-Heptyl, n-Octyl, 1,1,3,3-Tetramethylbutyl, n-Nonyl, n-Decyl, 2-Decyl, n-Dodecyl, n-Tetradecyl, n-Hexadecyl, n-Octadecyl, Tridec-7-yl, Heptadec-9-yl, 2,6,10-Trimethyldodecyl und 2,6,10,14-Tetramethylhexadecyl.

Bevorzugt weisen Alkylgruppen $R_1$ bis $R_4$, $R_7$ und $R_7'$ 1-10 C-Atome auf. Als Alkylgruppen $R_1$ bis $R_4$ sind solche mit 1-4 C-Atomen und vor allem Methyl oder Aethyl ganz besonders bevorzugt.

Bedeuten $R_1$ bis $R_4$ Halogenatome oder sind solche Reste durch Halogenatome substituiert, so handelt es sich dabei z. B. um Fluor- und vor allem Chlor- oder Bromatome.

Als Beispiele von Halogenalkylgruppen $R_1$ bis $R_4$ seien genannt: $—CCl_3$, $—CBr_3$, $—CF_3$, $—CH_2CH_2Cl$, $—CH_2CH_2Br$, $—(CH_2)_3Cl$ und $—CH_2CH(Cl)CH_2CH_3$.

Stellen $R_1$ bis $R_4$ oder $R_7/R_7'$ Hydroxyalkylgruppen dar, so handelt es sich z. B. um die Hydroxymethyl-, 2-Hydroxyäthyl-, 2- oder 3-Hydroxypropyl-, 4-Hydroxybutyl-, 5-Hydroxypentyl- oder 2-Hydroxyhexylgruppe. n ist vorzugsweise eine Zahl von 1-10, besonders 1-4.

Bedeuten $R_1$ bis $R_4$ $—C_dH_{2d}—COOH$ oder $R_7/R_7'$ $—C_dH_{2d}—OCO—C(X)=CH_2$ oder Alkylphenyl, so können die $—C_dH_{2d}—$ oder Alkylgruppen in diesen Resten geradkettig oder verzweigt sein. Bevorzugt sind die genannten Gruppen geradkettig. Als Alkylphenylgruppen kommen vor allem derartige Gruppen mit 1-2 C-Atomen im Alkyl in Betracht, wie Methylphenyl und Aethylphenyl. Stellen $R_7$ oder $R_7'$ Phenyläthyl dar, so handelt es sich vor allem um die 2-Phenyläthylgruppe.

Bevorzugt verwendet man Verbindungen der Formel I, worin $R_3$ und $R_4$ Wasserstoff sind, $R_1$ ein Halogenatom, besonders Chlor oder Brom, $C_{1-4}$-Alkyl, $—SR_7'$, $—COOR_7$, $—CON(R_7)_2$, Chlor- oder Bromalkyl mit 1- oder 2 C-Atomen, $—CO—O[CH_2CH(X)O]_2—X$ oder

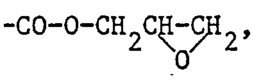

$R_2$ Wasserstoff, $C_{1-4}$-Alkyl $C_{1-3}$-Alkoxy, $—COOR_7$, Phenylsulfonyl, $—NO_2$, $—O[CH_2CH(X)O]_n—X$, $—CO—O[CH_2CH(X)O]_n—X$ oder

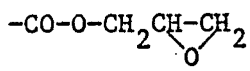

oder

$R_1$ und $R_2$ in ortho-Stellung zueinander gebunden sind und zusammen —CO—O—CO— oder $—CO—N(R_7)—CO$ darstellen,

$R_5$ und $R_6$ je Wasserstoff oder zusammen $—CH_2—$, —S—, —O—, —CO— oder —NH— und

$R_7$ $C_{1-10}$-Alkyl, $C_{1-4}$-Hydroxyalkyl, $C_{1-4}$-Alkyl$—OCO—C(X)=CH_2$, Cyclohexyl oder Allyl darstellen,

$R_7'$ dieselbe Bedeutung wie $R_7$ hat, aber ungleich Wasserstoff ist, n eine Zahl von 1-10, Y —CO— und X Wasserstoff oder Methyl bedeuten.

Besonders bevorzugt verwendet man Stoffgemische, die 4 bis 7 Gewichtsprozent einer Verbindung der Formel I, worin $R_1$ in 2-Stellung gebunden ist und $—COO—C_{1-6}$-Alkyl, besonders —COO-n-Butyl, oder

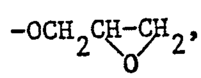, $R_2$,

$R_3$ und $R_4$ Wasserstoff, $R_5$ und $R_6$ zusammen —CO— und Y —CO— darstellen, sowie 87 bis 93 Gewichtsprozent der Komponente b) und 3 bis 6 Gewichtsprozent der Komponente c) enthalten.

Gemäss einer weiteren Bevorzugung verwendet man Stoffgemische, die 4 bis 7 Gewichtsprozent einer Verbindung der Formel I, worin $R_3$ und $R_4$ Wasserstoff sind, $R_1$ und $R_2$ in 1-, 2- und/oder 3-Stellung gebunden sind und $R_1$ —COO—$C_{1-6}$-Alkyl und $R_2$ Wasserstoff, Phenylsulfonyl oder —$NO_2$ bedeuten, oder $R_1$ und $R_2$ in 3,4-Stellung gebunden sind und je —COO—$C_{1-6}$-Alkyl oder —$COO(CH_2CH_2O)_n$—$CH_3$ mit n = 2 oder 3 oder zusammen —CO—N($R_7$)—CO— darstellen, wobei $R_7$ $C_{2-8}$-Alkyl oder Allyl ist, $R_5$ und $R_6$ zusammen —S— und Y —CO— bedeuten, sowie 87 bis 93 Gewichtsprozent der Komponente b) und 3 bis 6 Gewichtsprozent der Komponente c) enthalten, vor allem Stoffgemische, die 4 bis 7 Gewichtsprozent einer Verbindung der Formel I, worin $R_1$ in 1-Stellung gebunden ist und —COO—$C_{1-6}$-Alkyl, besonders —COO-n-Butyl, bedeutet, $R_2$ in 3-Stellung gebunden ist und Wasserstoff, —$NO_2$ oder Phenylsulfonyl darstellt oder $R_1$ und $R_2$ in 3,4-Stellung gebunden sind und je —COO—$C_{1-6}$-Alkyl oder —$COO(CH_2CH_2O)_2CH_3$ oder zusammen —CO—N($C_{2-8}$-Alkyl)—CO— darstellen $R_3$ und $R_4$ Wasserstoff, $R_5$ und $R_6$ zusammen —S— und Y —CO— bedeuten, sowie 87 bis 93 Gewichtsprozent der Komponente b) und 3 bis 6 Gewichtsprozent der Komponente c) enthalten.

Die Verbindungen der Formel I sind bekannt oder können nach an sich bekannten Methoden hergestellt werden. Thioxanthone und Xanthone der Formel I können z. B. analog den in der deutschen Offenlegungsschrift 31 17 568 (A 1) beschriebenen Methoden erhalten werden.

Als definitionsgemässe Polymere mit H-Donorgruppen kommen vor allem Polymere mit Hydroxyl-, NH-, N-Alkyl-, besonders $N(CH_3)_2$-Gruppen, in Betracht, wie z. B. Gelatine oder teilweise verseifte Celluloseester, z. B. Celluloseacetat. Als Polymere mit H-Donorgruppen können ferner Polymerisations-, Polykondensations- oder Polyadditionsprodukte verwendet werden. Als Polymerisationsprodukte kommen insbesondere Polymere in Betracht, die aus gleichen oder verschiedenen wiederkehrenden Strukturelementen der Formel II

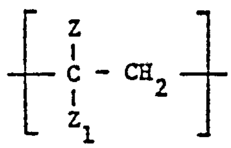

(II)

bestehen, worin

Z Wasserstoff, Chlor oder Methyl,

$Z_1$ Wasserstoff, Chlor, Methyl, —OH, —CN, —COOH, —$CONH_2$, Phenyl, Methylphenyl, Methoxyphenyl, Cyclohexenyl, Imidazolyl, Pyrrolidonyl, —COO-Alkyl mit 1-12 C-Atomen im Alkyl, —COOPhenyl,

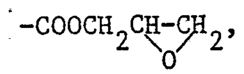

—COO-Alkylen—OH mit 2-12 C-Atomen im Alkylen, —$COO(CH_2CH_2O)_p$—H oder —$COO[CH_2CH(CH_3)O]_p$—H mit p = 2-4, —OCOAlkyl mit 1-4 C-Atomen im Alkyl, —OCOPhenyl, —COAlkyl mit 1-4 C-Atomen im Alkyl, $C_{1-12}$-Alkoxy, Phenoxy, Hydroxymethylphenyl, —CONH—$C_{1-4}$-Alkylen—OH, —COO—$C_{1-4}$-Alkylen—N(Q') (Q'') oder —$OCO(CH_2)_x$—OH mit x = 2-5,

Q' Wasserstoff oder $C_{1-5}$-Alkyl und Q'' $C_{1-5}$-Alkyl darstellen, wobei $Z_1$ in mindestens 20 % der Strukturelemente der Formel II OH, —COO—$C_{2-12}$-Alkylen—OH, —$COO(CH_2CH_2O)_p$—H, —$COO[CH_2CH(CH_3)O]_p$—H, —$OCO(CH_2)_x$—OH mit x = 2-5, Hydroxymethylphenyl, —CONH—$C_{1-4}$-Alkylen—OH oder —COO—$C_{1-4}$-Alkylen—N—(Q') (Q'') bedeutet.

Handelt es sich dabei um Copolymere, so können die verschiedenen Strukturelemente in statistischer oder blockartiger Anordnung (Blockcopolymere oder Pfropfcopolymere) vorliegen.

Alkoxygruppen $Z_1$ und Alkyl- oder Alkylengruppen in Resten $Z_1$ können geradkettig oder verzweigt sein.

Stellt $Z_1$ definitionsgemäss —COOAlkyl, —COO-Alkylen—OH, —$COO(CH_2CH_2O)_p$—H, —$COO[CH_2CH(CH_3)O]_p$—H, —OCO-Alkyl, —COAlkyl, Alkoxy, —CONH—$C_{1-4}$-Alkylen—OH, —COO-Alkylen—N(Q') (Q'') oder —$OCO(CH_2)_x$—OH dar, so handelt es sich beispielsweise um die folgenden Reste : —COOMethyl, —COOAethyl, —COO-n-Propyl, —COOIsopropyl, —COO-n-Butyl, —COO-n-Pentyl, —COO-n-Hexyl, —COO-2-Aethylhexyl, —COO-n-Octyl, —COO-n-Decyl, —COO-n-Dodecyl ; —$COOCH_2CH_2OH$, —$COOCH_2CH(OH)CH_3$, —$COO(CH_2)_3$—OH, —$COOCH(CH_3)_2OH$, —$COOCH_2CH(CH_3)_2$—OH, —$COO(CH_2)_4$—OH, —$COO(CH_2)_6$—OH, —$COO(CH_2)_8$—OH, —$COO(CH_2)_{10}$—OH, —$COO(CH_2)_{12}$—OH ; —$OCOCH_3$, —$OCOC_2H_5$, —OCO-n-Propyl, —OCO-Isopropyl, —OCO-n-Butyl ; —$COCH_3$, —$COC_2H_5$—, —CO-n-Propyl, —CO-Isopropyl, —CO-n-Butyl ; Methoxy, Aethoxy, n-Propoxy, Isopropoxy, n-Butoxy, n-Hexyloxy, 2-Aethylhexyloxy, n-Octyloxy, n-Decyloxy, n-Dodecyloxy ; —CONH—$(CH_2)_2$—OH, —CONH—$(CH_2)_3$—OH, —CONH—$(CH_2)_4$—OH ; —$COO(CH_2)_2N(CH_3)_2$, —$COO(CH_2)_2N(C_2H_5)_2$, —$COO(CH_2)_3N(CH_3)_2$, —$COO(CH_2)_2$N(n-Propyl)$_2$, —$COO(CH_2)_4N(CH_3)_2$, —$COO(CH_2CH_2O)_2$—H, —$COO[CH_2CH(CH_3)O]_2$—H, —$COO(CH_2CH_2O)_3$—H, —$COO[CH_2CH_2(CH_3)O]_3$—H, —$OCO(CH_2)_2$—OH, —$OCO(CH_2)_3$—OH oder —$OCO(CH_2)_4$—OH.

$Z_1$ bedeutet vorzugsweise in 20 bis 97,5 und insbesondere 20 bis 70 % der Strukturelemente der Formel II —OH, —COO—$C_{2-12}$-Alkylen—OH, Hydroxymethylphenyl, —CONH—$C_{1-4}$-Alkylen—OH, —COO—$C_{1-4}$-Alkylen—N(Q') (Q''), —$COO(CH_2CH_2O)_p$—H, —$COO[CH_2CH(CH_3)O]_p$—H oder —O-$CO(CH_2)_x$—OH mit x = 2-5.

Bevorzugt sind Polymere aus Strukturelementen der Formel II, worin Z Wasserstoff, Chlor oder Methyl und $Z_1$ Wasserstoff, Chlor, CN, Methyl, Phenyl, Methylphenyl, Methoxyphenyl, —COO—$C_{1\text{-}10}$-Alkyl, —COOPhenyl,

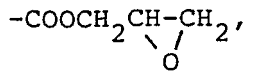

—COO—$C_{2\text{-}12}$-Alkylen—OH, —CO-Alkyl mit 1-4 und besonders einem oder zwei C-Atomen, Alkoxy mit 1-8 und besonders 1-4 C-Atomen, Phenoxy, Hydroxymethylphenyl, —$CONH(CH_2)_2$—OH, —O-$CO(CH_2)_x$—OH mit x = 2-5, oder —COO—$C_{1\text{-}4}$-Alkylen—N($C_{1\text{-}4}$-Alkyl)$_2$ darstellen, wobei der Anteil an Gruppen $Z_1$ = —COO—$C_{2\text{-}12}$-Alkylen—OH, Hydroxymethylphenyl, —$CONH(CH_2)_2OH$, —O-$CO(CH_2)_x$—OH oder —COO—$C_{1\text{-}4}$-Alkylen-N($C_{1\text{-}4}$-Alkyl)$_2$ 20 bis 70 % beträgt.

Besonders bevorzugt sind Polymere aus Strukturelementen der Formel II, worin Z Wasserstoff oder Methyl und $Z_1$ Methyl, Phenyl, Methylphenyl, —COO—$C_{1\text{-}10}$-Alkyl, —COO—$C_{2\text{-}12}$-Alkylen—OH, Hydroxymethylphenyl oder —COO—$C_{1\text{-}4}$-Alkylen—$N(CH_3)_2$ darstellen, wobei der Anteil an Gruppen —COO—$C_{2\text{-}12}$-Alkylen—OH, Hydroxymethylphenyl oder —COO—$C_{1\text{-}4}$-Alkylen-$N(CH_3)_2$ 20 bis 70 % beträgt.

Ganz besonders bevorzugt verwendet man Polymere aus Strukturelementen der Formel II, worin in 55-65 % der Strukturelemente Z Wasserstoff und besonders Methyl und $Z_1$ —$COO(CH_2)_2N(CH_3)_2$ und vor allem —$COO(CH_2)_2OH$, —$COOCH_2CH(CH_3)$—OH oder —$COOM(CH_2)_3OH$ und in 35-45 % der Strukturelemente Z Wasserstoff oder Methyl und $Z_1$ Phenyl oder —COO—$C_{1\text{-}8}$-Alkyl, besonders —COOMethyl, —COOAethyl oder —COO-2-Aethylhexyl bedeuten.

Als Polykondensations- oder Polyadditionsprodukte kommen insbesondere solche in Betracht, die gleiche oder verschiedene Strukturelemente der Formeln III, IV, V oder VI

$$-[NH-A-NH-CO-A_1CO]- \qquad (III)$$

$$-[CH_2CH(OH)CH_2-O-A_2-O]-[CH_2CH(OH)CH_2-A_3]_{y-1}- \qquad (IV)$$

oder

$$-[CH_2CH(OH)CH_2-\underset{|}{N}-A-\underset{|}{N}]- \qquad (V)$$

$$-[CH_2CH(OH)CH_2-OCO-A_1-COO]- \qquad (VI)$$

und gegebenenfalls Strukturelemente der Formel VII

$$—[CO—A_1—CO—C—A_4—O—]— \qquad (VII)$$

aufweisen, worin y die Zahl 1 oder 2,

A —$C_mH_{2m}$— mit m = 2-12, Cyclohexylen, Naphthylen, gegebenenfalls durch eine Methyl-, Methoxy- oder Nitrogruppe substituiertes Phenylen, 1,3- oder 1,4-Xylylen, den Rest des 4,4'-Diaminodicyclohexylmethans, 4,4'-Diaminodiphenylmethans, 4,4'-Diaminodiphenyläthers, 4,4'-Diaminodiphenylsulfons oder Isophorondiamins,

$A_1$ die direkte Bindung, —$C_mH_{2m}$— mit m = 2-12, Cyclohexylen, Cyclohexenylen, Endomethylencyclohexenylen oder Phenylen, die durch —$CH_3$ substituiert sein können,

$A_2$ —$C_mH_{2m}$— mit m = 2-12, Phenylen,

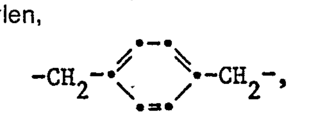

eine Gruppe der Formeln

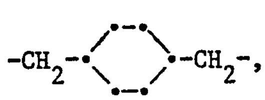, 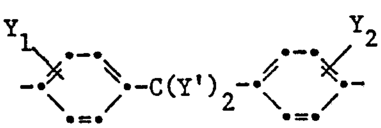 oder $-(Y_3O)_o-Y_3-$,

Y' Wasserstoff oder Methyl,

$Y_1$ und $Y_2$ unabhängig voneinander Wasserstoff, Chlor oder Brom,

$Y_3$ —$(CH_2)_2$—, —$CH_2CH(CH_3)$— oder —$(CH_2)_4$—

o eine Zahl von 1-50,

$A_3$

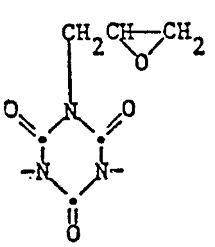,

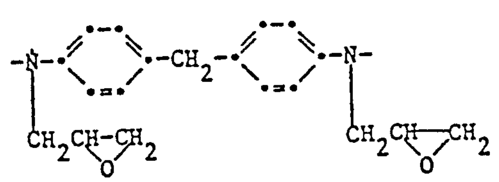

den Rest des Aethylenharnstoffs, Propylenharnstoffs, 5,5-Dimethylhydantoins, 2-Hydroxyäthyl- oder 2-Hydroxypropyl-5,5-dimethylhydantoins und $A_4$ $-C_mH_{2m}-$ mit m = 2-12, $-(CH_2CH_2O)_r-CH_2CH_2-$ mit r = 1-40 und besonders 1-20, $-CH(CH_3)CH_2OCH_2CH(CH_3)-$, Cyclohexylen, $-CH_2C(CH_3)_2-CH_2-O-CO-C(CH_3)_2-CH_2-$

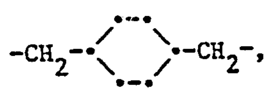, 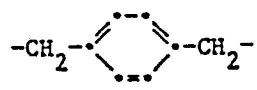, 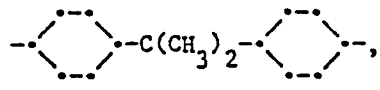,

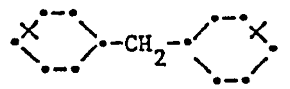,

Naphthylen, Biphenylen oder gegebenenfalls durch eine Methyl-, Methoxy- oder Nitrogruppe substituiertes Phenylen darstellen.

In den Polymeren der Formeln III bis VII können die einzelnen A, $A_1$, $A_2$, $A_3$ und $A_4$ gleiche oder unterschiedliche Bedeutung haben, und die wiederkehrenden Strukturelemente in diesen Polymeren können statistisch oder blockartig angeordnet sein. Definitionsgemäss können auch Gemische von Polymeren mit H-Donorgruppen und H-donorgruppenfreien Polymeren vorliegen, z. B. Gemische von Polymeren mit Strukturelementen der Formeln III bis VI mit Polymeren, die aus wiederkehrenden Strukturelementen der Formel VII bestehen.

Durch A, $A_1$, $A_2$ oder $A_4$ dargestellte Gruppen $-C_mH_{2m}-$ können geradkettig oder verzweigt sein und weisen vorzugsweise 2-10 C-Atome auf. Als Beispiele solcher Gruppen seien genannt : $-(CH_2)_2-$, $-CH_2CH(CH_3)-$, $-(CH_2)_3-$, $-(CH_2)_4-$, $-(CH_2)_2-C(CH_3)_2-(CH_2)_2-$, $-(CH_2)_6-$, $-C(CH_3)_2-$, $-CH_2C(CH_3)_2-CH_2-CH(CH_3)$ $(CH_2)_2-$, $-CH_2CH(CH_3)CH(CH_3)CH_2CH-(CH_3)CH_2-$, $-(CH_2)_7-$, $-(CH_2)_8-$, $-(CH_2)_{10}-$ und $-(CH_2)_{12}-$.

Stellen $A_2$ und/oder $A_4$ Gruppen $-C_mH_{2m}-$ dar, so handelt es sich insbesondere um Reste des Aethylenglykols, 1,4-Butandiols, Neopentylglykols oder 1,6-Hexandiols. Ist $A_1$ eine Gruppe $-C_mH_{2m}-$, so kommen vor allem Reste der Bernsteinsäure-, Adipinsäure, Pimelinsäure, Azelainsäure und Sebacinsäure in Betracht. A als Rest $-C_mH_{2m}-$ ist bevorzugt $-(CH_2)_2-$, Trimethylen, Tetramethylen, Hexamethylen, $-CH_2CH(CH_3)CH(CH_3)CH_2CH(CH_3)CH_2-$ oder $-CH_2C(CH_3)_2CH_2CH(CH_3)CH_2CH_2-$.

Bedeutet $A_4$ Cyclohexylen, so handelt es sich insbesondere um den Rest des 1,2-Cyclohexandiols. Als Cyclohexylengruppen A und $A_1$ kommen vor allem 1,3- und insbesondere 1,4-Cyclohexylen in Betracht.

Stellt $A_4$ Naphthylen, Biphenylen oder gegebenenfalls durch eine Methyl-, Methoxy- oder Nitrogruppe substituiertes Phenylen dar, so kommen z. B. Reste des 1,4-, 1,6-, 1,8- und 2,6-Dihydroxynaphthalins, des 2,2'-Biphenyls, Resorcins, 2,5-Dihydroxyanisols, 1,2-Dihydroxy-4-nitrobenzols, 2,5- und 3,4-Dihydroxytoluols in Betracht. Bevorzugt bedeutet $A_4$ $-(CH_2)_2-$, $-(CH_2)_4-$, $-(CH_2)_6-$, $-CH_2CH_2OCH_2CH_2-$, $-C(CH_3)_2-$

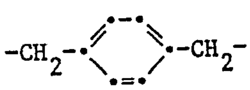

oder 1,3-Phenylen.

Bedeutet $A_1$ gegebenenfalls durch Methyl substituiertes Cyclohexenylen, Phenylen oder Endomethylencyclohexylen, so handelt es sich beispielsweise um Reste der Tetrahydrophthalsäure, Phthalsäure, Methyl-tetrahydrophthalsäure, Endomethylentetrahydrophthalsäure, Isophthalsäure oder Terephthalsäure. $A_1$ ist bevorzugt $-(CH_2)_m-$ mit m = 2-10, 1,3- oder 1,4-Phenylen, 1,3- oder 1,4-Cyclohexylen.

Ist A Naphthylen oder gegebenenfalls durch eine Methyl-, Methoxy- oder Nitrogruppe substituiertes Phenylen, so kommen z. B. die folgenden Reste in Betracht : 1,2-, 1,3- oder 1,4-Phenylen, 4-Methoxy-1,3-phenylen, 2-Nitro-1,4-phenylen, o- und m-Tolylen, 1,5- und 1,8-Naphthylen. Vorzugsweise stellt A $-C_mH_{2m}-$ mit m = 2-10, 1,3- oder 1,4-Phenylen oder den Rest des 4,4'-Diaminodiphenyalmethans, 4,4'-Diaminodiphenyläthers oder Isophorondiamins dar.

Ist $A_2$ Phenylen, so handelt es sich insbesondere um 1,3-Phenylen. Bedeutet $A_2$ eine Gruppe der Formel

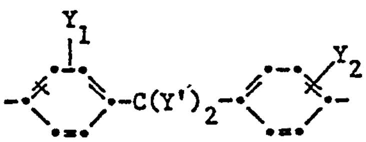,

so stellen $Y_1$ und $Y_2$ vorzugsweise je in 2,2'-Stellung gebundenes Chlor oder Brom dar. Besonders bevorzugt sind jedoch solche Gruppen, worin $Y_1$ und $Y_2$ Wasserstoff bedeuten.

Stellt $A_2$ eine Gruppe $-(Y_3O)_o-Y_3-$ dar, so ist $Y_3$ bevorzugt $-(CH_2)_2-$ oder $-CH_2CH(CH_3)-$ und o stellt insbesondere 1-40, vor allem 2-20, dar.

$A_2$ ist bevorzugt $-C_mH_{2m}-$ mit m = 2, 4 oder 6,

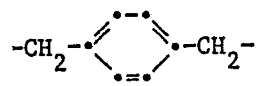

vor allem jedoch eine Gruppe der Formeln

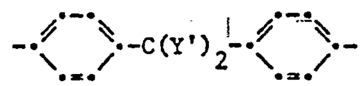 , $-(CH_2CH_2O)_o-CH_2CH_2-$

und/oder $-[CH_2CH(CH_3)O]_o-CH_2CH(CH_3)-$ mit Y' = H und vor allem Methyl und o = 1-40, vor allem 2-20.

$A_3$ ist vorzugsweise der Rest des Triglycidylisocyanurats, 5,5-Dimethylhydantoins, 2-Hydroxyäthyl- oder 2-Hydroxypropyl-5,5-dimethylhydantoins.

Besonders bevorzugt sind Additionsprodukte aus Diolen $HO-A_4-OH$,

Dicarbonsäuren $HOOC-A_1-COOH$, Carbonsäure-Endgruppen enthaltenden Oligoestern der Formel VIII

$$HO-[CO-A_1-CO-O-A_4-O]_s-CO-A_1-COOH \quad (VIII)$$

und/oder Diaminen $H_2N-A-NH_2$ mit Diglycidylverbindungen der Formel IX

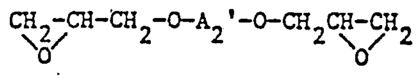 (IX)

worin

A $-(CH_2)_m-$ mit m = 4-10, den Rest des 4,4'-Diaminodiphenylmethans, 4,4'-Diaminodiphenyläthers oder Isophorondiamins,

$A_1$ $-(CH_2)_m-$ mit m = 2-10, 1,3- oder 1,4-Phenylen, 1,3- oder 1,4-Cyclohexylen,

s eine Zahl von 1-100, besonders 1-20,

$A_2'$ $-C_mH_{2m}-$ mit m = 2, 4 oder 6, eine Gruppe der Formeln

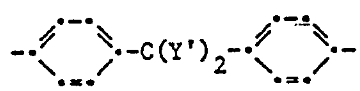 , $-(CH_2CH_2O)_o-CH_2CH_2-$

und/oder $-[CH_2CH(CH_3)O]_o-CH_2CH(CH_3)-$ mit Y' = H und vor allem Methyl und o = 1-40, vor allem 2-20, oder ein Oligomeres der Formel X

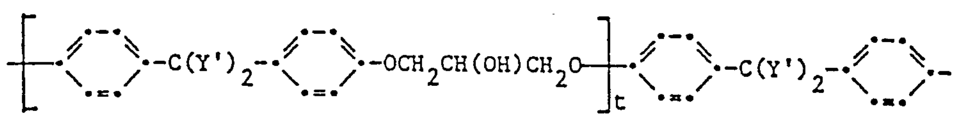 (X)

mit t = 1,2 bis 12 und Y' = H und insbesondere Methyl und $A_4$ $-C_mH_{2m}-$ mit m = 2-12, $-(CH_2CH_2O)_r-CH_2CH_2-$ mit r = 1-40, besonders 1-20, $-CH(CH_3)CH_2OCH_2CH(CH_3)-$, 1,2-Cyclohexylen, 2,2'-Biphenylen oder 1,3-Phenylen bedeuten.

Ganz besonders sind Additionsprodukte aus Diolen der Formel XI

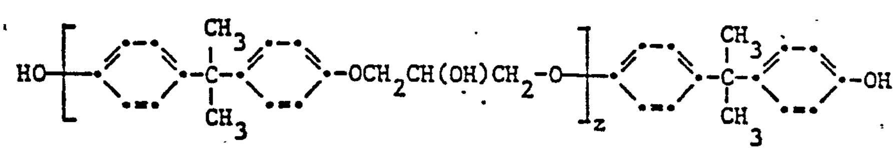 (XI)

und Diglycidylverbindungen der Formeln XII oder XIII

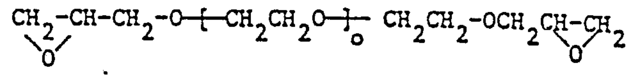 (XII)

oder

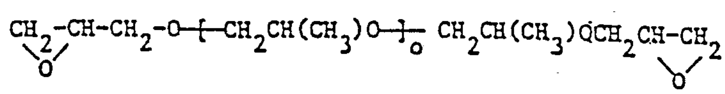 (XIII)

bevorzugt, worin z eine Zahl von 1-8 und o eine Zahl von 1-10 bedeuten.

Weitere geeignete Additionsprodukte sind Glycidyl-Phenolnovolacke und -Kresolnovolacke und Additionsprodukte von Diolen oder Dicarbonsäuren der oben genannten Art an Triglycidylisocyanurat.

Sind die erfindungsgemäss einzusetzenden Polymeren linear, so weisen sie vorzugsweise ein durchschnittliches Molekulargewicht von 2 000 Dalton bis zu 1 000 000 und insbesondere zwischen 2 000 und 150 000 Dalton auf. Das durchschnittliche Molekulargewicht der Polymeren kann nach an sich bekannten Methoden bestimmt werden, z. B. mittels Osmometrie oder Lichtstreuung.

Die erfindungsgemäss einzusetzenden Stoffgemische können auch weitere Zusätze enthalten, insbesondere Lösungsmittel und/oder Vernetzungsmittel. Geeignete Lösungsmittel sind z. B. N,N-Dialkylamide von aliphatischen Monocarbonsäuren mit 1-3 C-Atomen im Säureteil, wie N,N-Dimethylformamid, N,N-Dimethylacetamid und N,N-Diäthylacetamid ; Mono- und Dialkyläther von Aethylenglykol und Diäthylenglykol mit je 1-4 C-Atomen in den Alkylgruppen, wie Aethylenglykolmonomethyl-, -monoäthyl- und -mono-n-butyläther, Aethylenglykoldimethyl- und -diäthyläther, Diäthylenglykolmonomethyl-, -monoäthyl- und -mono-isopropyläther, Diäthylenglykoldimethyl- und -diäthyläther ; ferner cyclische Amide, wie N-Methylpyrrolidon ; Dialkylsulfoxide, wie Dimethyl- und Diäthylsulfoxid ; Chlorbenzol und Ester der Kohlensäure, wie Kohlensäurepropylenglykolester und Diäthylcarbonat.

Als Vernetzungsmittel können je nach Art der in den Polymeren vorhandenen funktionellen Gruppen z. B. zwei oder höherwertige Alkohole oder Amine, Di-, Tri- oder Tetracarbonsäuren oder Derivate davon, wie Anhydride, eingesetzt werden. Als Beispiele geeigneter mehrfunktioneller Verbindungen seien genannt : Diole $HO—A_2—OH$, $HO—A_4—OH$, Dicarbonsäuren $HOOC—A_1—COOH$ und Derivate davon, Oligoester der Formel VIII sowie Diamine $H_2N—A—NH_2$, worin s, A, $A_1$, $A_2$ und $A_4$ die oben angegebene Bedeutung haben ; ferner Glycerin, Tris-(hydroxymethyl)-äthan und -propan, Pentaerythrit, Diäthylentriamin, Triäthylentetramin, Bernsteinsäureanhydrid, Glutarsäureanhydrid, Phthalsäureanhydrid, Tetrahydrophthalsäureanhydrid, Hexahydrophthalsäureanhydrid, Trimellitsäureanhydrid, Pyromellitsäuredianhydrid und Benzophenontetracarbonsäuredianhydride. Für die Vernetzung von Polymeren mit OH-Gruppen oder entständigen Glycidylgruppen verwendet man vorzugsweise Di- oder Polycarbonsäuren oder Carbonsäureanhydride, wie Hexahydrophthalsäureanhydrid oder Phthalsäureanhydrid bzw. zwei oder mehrwertige Alkohole, besonders Bisphenol A.

Eine gewisse Vernetzung der erfindungsgemäss zu verwendenden Stoffgemische kann auch durch Rekombination der bei der Belichtung der lichtempfindlichen Verbindungen der Formel I in Gegenwart von Polymeren mit H-Donorgruppen gebildeten H-Donorradikale zustande kommen. Für diese Art der Vernetzung werden relativ niedrige Strahlungsenergien benötigt. Unter Umständen erfolgt eine derartige Vernetzung schon bei Raumtemperatur. Die chemische Vernetzung ist jedoch bevorzugt.

Als Salze von Metallen der Gruppen Ia und VIII des Periodischen Systems eignen sich Salze mit organischen oder anorganischen Säuren oder Gemischen davon, wie Carboxylate, z. B. Formiate, Acetate, Stearate, Gluconate und Citrate ; Halogenide, Nitrate, Sulfate und Perchlorate. Als Beispiele seien genannt : Eisen(III) acetat, -citrat, -gluconat, -nitrat-, -sulfat und -perchlorat ; Eisen(II)- oder Eisen(III) chlorid, Eisen(II) oxalat ; Ruthenium(III) chlorid ; Kobalt(II) acetat, -nitrat oder -sulfat ; Kobalt(II) chlorid oder -bromid ; Rhodium(II) acetat, Rhodium(III) chlorid ; Nickel(II) acetat, Nickel(II) bromid und -chlorid, Nickel(II) sulfat ; Palladium(II) chlorid und -jodid, Palladiumacetat und -nitrat ; Kupfer(II) formiat und -acetat, Kupfer(I)- oder -(II)-chlorid, -bromid und -jodid, Kupfer(II) nitrat oder -sulfat ; Silberacetat, -chlorid, -bromid, -nitrat oder -sulfat.

Besonders bevorzugt sind Kupfer(II) carboxylate, vor allem Kupfer(II)-acetat, gegebenenfalls im Gemisch mit Kupfer(II) halogeniden, besonders Kupfer(II) bromid. Wie schon erwähnt, können die erfindungsgemäss zu verwendenden Polymeren mit H-Donorgruppen durch diese Metallsalze teilweise komplexiert werden.

In dem Verfahren zum Erzeugen von Abbildungen auf organischen oder anorganischen Substraten, besonders von elektrisch leitenden Ueberzügen oder Mustern, vor allem gedruckten Schaltungen, wird ein erfindungsgemäss zu verwendendes Stoffgemisch unter Erzeugung von nullwertigen, nicht-leitenden Metallkeimen belichtet und anschliessend darauf stromlos ein Metall, wie Kupfer, Nickel, Kobalt, Silber, Zinn oder dergleichen, abscheidet. Die so erhaltenen Abbildungen können gewünschtenfalls durch elektrolytische Metallabscheidung mit konventionellen Metallabscheidungsbädern verstärkt werden. Dabei wird das Gemisch aus Verbindung der Formel I, Polymer oder Polymergemisch mit H-Donorgruppen und Metallsalz sowie gegebenenfalls Vernetzungsmitteln zweckmässig in einem geeigneten Lösungsmittel gelöst, auf das Substrat appliziert und dann durch eine Photomaske belichtet. Als Lösungsmittel können z. B. solche der oben genannten Art verwendet werden. Geeignete Substrate sind z. B. Glas, Metalle und Metalloxide, wie Aluminium, Aluminiumoxid und Kupfer, Keramik, Papier und hochmolekulare organische Materialien. Als hochmolekulare organische Materialien kommen natürliche und synthetische Polymere in Betracht, z. B. Cellulosematerialien, wie Celluloseacetate, Cellulosepropionate, Cellulosebutyrate und Celluloseäther, wie Methylcellulose ; von α,β-ungesättigten Säuren abgeleitete Polymere, wie Polyacrylate und Polymethacrylate, Polyacrylamide und Polyacrylnitril ; Styrolpolymere und Copolymere davon z. B. Styrol-Butadiencopolymere und Acrylnitril/Butadien/Styrolcopolymere ; Vinyl- und Vinylidenpolymere und Copolymere davon, wie Polyvinylchlorid, Polyvinylidenchlorid, Vinylchlorid/Vinylidenchloridcopolymere, Vinylchlorid/Vinylacetatcopolymere ; von ungesättigten Alkoholen und Aminen abgeleitete Polymere und Derivate davon, wie Polyvinylalkohol, Polyvinylacetat und Polyallylmelamin ; vernetzte Epoxidbare ; Polyacetate ; Polyalkylenoxide und Polyphenylenoxide ; Polyamide, Polyimide, Polyamid-Polyimid-Blockcopolymere, Polysulfone und Polyester; Alkydharze, z. B. Glycerin/Phthalsäureharz und deren Mischungen mit Melamin/Formaldehydharzen, Melamin-Formaldehyd-, Harnstoff-Formaldehyd-, Phenol-Formaldehydharze, usw.

Für die Belichtung der erfindungsgemässen Stoffgemische können an sich beliebige geeignete Lichtquellen eingesetzt werden, z. B. Xenonlampen, Metallhalogenidlampen und besonders Quecksilberhoch- und mitteldrucklampen.

## Beispiele 1-9

a) Herstellung des Matrixpolymeren

78,0 g Methacrylsäure-2-hydroxyäthylester und 73,6 g Acrylsäure-2-äthylhexylester werden in 600 ml Dioxan gelöst und unter Rühren und Inertgas auf 70 °C erhitzt und dann mit 1,42 g Azoisobutyronitril versetzt. Nach 2 Stunden bei 70 °C wird das Produkt durch Eintropfen in Eiswasser unter starkem Rühren gefällt. Ausbeute 142,9 g (94 % d. Th.). Tg : 42 °C ; [η] = 0,59 dl/g in N,N-Dimethylformamid bei 25 °C ; durchschnittliches Molekulargewicht 120 000 Dalton (bestimmt durch Lichtstreuung).

b) Erzeugung metallischer Bilder

Das gemäss a) hergestellte Polymer wird in N,N-Dimethylformamid mit jeweils 5 Gew.-% der in der folgenden Tabelle I angegebenen Verbindungen der Formel I und 5 Gew.% Kupfer(II) acetat versetzt. Der Feststoffgehalt der Lösung beträgt 30 Gew.%. Die Lösung wird mit einem Rollercoater als 50 μm dicker Nassfilm auf eine Polyesterfolie aufgestrichen, getrocknet und mit einer 5 kW-Quecksilberhochdruckklampe (Fa. Staub AG, Neu-Isenburg, BRD) durch einen 21-Stufenkeil (21 Step Sensitivity Guide Stouffer) bei 90 °C belichtet. Das erhaltene Bild wird in einem stromlosen Kupferabscheidungsbad der Zusammensetzung: Kupfersulfat 12 g/l, Formaldehyd 8 g/l, NaOH 15 g/l, Natriumkaliumtartrat 14 g/l, Aethylendiamintetraessigsäure 20 g/l, Octylphenolpolyäthylenglykoläther n ~ 1 (Tryton X 100® der Fa. Röhm + Haas) 1 g/l bei 49 °C zu einem metallischen, elektrisch leitenden Bild verstärkt. Die Resultate sind in der folgenden Tabelle I angegeben.

Tabelle I

| Bsp. Nr. | Verbindung der Formel I | letzte abgebildete Stufe nach 180" |
|---|---|---|
| 1 | Anthron | 1 |
| 2 | 2-Anthrachinoncarbonsäure-6-hydroxyhexylester | 2 |
| 3 | 3-Nitroxanthon-1-carbonsäureäthylester | 1 |
| 4 | Thioxanthon-1-carbonsäuremethylester | 2 |
| 5 | Thioxanthon-1-carbonsäure-n-butylester | 4 |
| 6 | 3-Phenylsulfonyl-thioxanthon-1-carbonsäureäthylester | 4 |
| 7 | 3-Nitrothioxanthon-1-carbonsäureäthylester | 4 |
| 8 | Thioxanthon-3,4-dicarbonsäure-di-n-butylester | 3 |
| 9 | Thioxanthon-3,4-dicarbonsäure-bis-[2-(2-methoxyäthoxy)äthyl]ester | 3 |
| 10 | 3-Phenylsulfonylthioxanthon-1-carbonsäure-(2-methacryloyloxy)-äthylester | 3 |

Beispiele 11-14

a) Herstellung des Matrixpolymeren

125,9 g Methacrylsäurehydroxypropylester (Gemisch aus 2- und 3-Hydroxypropylester) und 58,3 g Methacrylsäuremethylester werden in 416 ml Dioxan gelöst und unter Rühren und Inertgas auf 70 °C erhitzt und dann mit 0,92 g Azoisobutyronitril versetzt. Nach 12 Stunden bei 70 °C wird mit 500 ml Dioxan verdünnt. Dann wird das Polymer durch Fällen in 6 Liter Eiswasser isoliert. Ausbeute 169,3 g (91,5 % d. Th.). Tg : 90 °C ; [η] = 0,65 dl/g in N,N-Dimethylformamid bei 25 °C ; durchschnittliches Molekulargewicht 120 000 Dalton (bestimmt durch Lichtstreuung).

b) Erzeugung metallischer Bilder

Das gemäss a) hergestellte Polymer wird in N,N-Dimethylformamid gelöst und mit jeweils 5 Gew.% der in der folgenden Tabelle angegebenen Thioxanthonverbindungen sowie der äquimolaren Menge Kupfer(II) acetat versetzt. Der Feststoffgehalt der Lösung beträgt 30 Gew.%. Die Lösung wird dann mit einem Rollercoater als 50 µm starker Nassfilm auf eine Polyesterfolie aufgestrichen und durch eine Maske (21-Step Sensitivity Guide der Fa. Stouffer) auf einem Vakuumheiztisch bei 90 °C belichtet. Als Lichtquelle dient eine 5 kW Quecksilberhochdrucklampe (Fa. Staub, Neu-Isenburg, BRD). Das so erhaltene Bild auf Kupferkeimen wird in einem stromlosen Metallabscheidungsbad der Zusammensetzung : Kupfersulfat 12 g/l, Formaldehyd 8 g/l, NaOH 15 g/l, Natriumkaliumtartrat 14 g/l, Aethylendiamintetraessigsäure 20 g/l, Octylphenolpolyäthylenglykoläther 1 g/l bei 49 °C zu einem metallischen, elektrisch leitenden Bild verstärkt. Die Resultate sind in der Tabelle II angegeben.

Tabelle II

| Bsp.Nr. | Verbindung der Formel I | letzte abgebildete Stufe nach 4 Min. |
|---|---|---|
| 11 | Thioxanthon-3,4-dicarbonsäure-N-(2-äthyl-n-hexyl)imid | 8 |
| 12 | Thioxanthon-3,4-dicarbonsäure-N-n-octyl-imid | 4 |
| 13 | Thioxanthon-3,4-dicarbonsäure-di-n butylester | 7 |
| 14 | Thioxanthon-3,4-dicarbonsäure-bis-[2-(2-methoxyäthoxy)äthyl]ester | 2 |

Beispiele 15-24

a) 0,1 Mol (22,83 g) Bisphenol A und 0,09 Mol (31,19 g) Bisphenol-A-diglycidyläther werden zusammen mit 0,2 ml N,N-Dimethylbenzylamin in 150 ml Aethylenglykolmonoäthyläther gelöst und 4 Stunden bei 150 °C gerührt. Das so erhaltene Voraddukt lässt man auf 40 °C abkühlen und gibt dann 3,65 g eines Polyäthylenglykoldiglycidyläthers mit einem Epoxidäquivalent von 5,48 Aeq./kg zu. Man erhitzt erneut unter Rühren auf 150 °C, lässt weitere 3 Stunden bei 150 °C rühren und fällt das Polymere nach dem Abkühlen in Wasser. Ausbeute : 56,8 g (98 % d. Th.). Durchschnittliches Molekulargewicht (bestimmt durch Osmometrie) = 3 450 Dalton ; Tg = 59 °C ; Epoxidäquivalent : 0,088 Aeq./kg.

b) Analog a) wird ein Polymer aus 0,12 Mol Bisphenol A, 0,09 Mol Bisphenol-A-diglycidyläther, 0,08 Val eines Polyäthylenglykoldiglycidyläthers mit einem Epoxidäquivalent von 5,48 Aeq./kg hergestellt. Ausbeute : 68,1 g (93,06 % d. Th.). Durschnittliches Molekulargewicht (bestimmt durch Osmometrie) : 2 988 Dalton. Tg = 49 °C ; Epoxidäquivalent : 0,13 Aeq./kg.

c) Zur Prüfung der Photoempfindlichkeit werden 5 g Polymer, 200 mg Kupfer(II) acetat und 250 mg einer Verbindung der Formel I in N,N-Dimethylformamid gelöst und mittels eines Rollercoaters als Film auf einen Polyesterträger aufgebracht. Der Film wird durch einen Stufenkeil (21 Stufen) mit einer 5 kW Metallhalogenid-Quecksilberlampe bei 90 °C belichtet und dann wie in den Beispielen 1-10 beschrieben in einem stromlosen Kupferabscheidungsbad behandelt.

d) Zur Herstellung vernetzter Systeme werden die Reaktionskomponenten wie unter c) angegeben in N,N-Dimethylformamid gelöst und mit Hexahydrophthalsäureanhydrid versetzt. Aus der erhaltenen

Lösung wird ein Film hergestellt und 2 Stunden bei 120 °C getrocknet. Nach der Belichtung und stromlosen Metallabscheidung wie in den Beispielen 1-10 beschrieben werden Metallbilder erhalten.

e) Formulierungen gemäss Absatz d) werden zusätzlich mit jeweils 0,5 g Polyäthylenglykol mit einem durchschnittlichen Molekulargewicht von 3 280 Dalton (bestimmt durch Osmometrie) versetzt und in gleicher Weise wie unter d) beschrieben verarbeitet. Die Resultate sind in der Tabelle III angegeben.

Tabelle III

| Bsp. Nr. | Verbindung der Formel I | g Polymer nach Beispiel | g Hexahydrophthalsäure | letzte abgebildete Stufe nach 300" |
|---|---|---|---|---|
| 15 | 0,25 g 2-Anthrachinoncarbonsäure-2-äthoxyäthylester | 5 g nach a) | 0 | 1 |
| 16 | 0,25 g 2-Anthrachinoncarbonsäure-2-äthoxyäthylester | 5 g nach b) | 0 | 3 |
| 17 | 0,25 g 2-Anthrachinoncarbonsäure-2-äthoxyäthylester | 5 g nach a) | 0,067 | 1 |
| 18 | 0,25 g 2-Anthrachinoncarbonsäure-2-äthoxyäthylester | 5 g nach b) | 0,102 | 1 |
| 19 | 0,25 g Thioxanthon-1-carbonsäure-methylester | 5 g nach a) | 0 | 4 |
| 20 | 0,25 g Thioxanthon-1-carbonsäure-methylester | 5 g nach b) | 0 | 6 |
| 21 | 0,25 g Thioxanthon-1-carbonsäure-methylester | 5 g nach a) | 0,067 | 1 |
| 22 | 0,25 g Thioxanthon-1-carbonsäure-methylester | 5 g nach b) | 0,102 | 2 |
| 23 | 0,25 g Thioxanthon-1-carbonsäure-methylester | 5 g nach a) | 0,067 | 2 |
| 24 | 0,25 g Thioxanthon-1-carbonsäure-methylester | 5 g nach b) | 0,102 | 2 |

Beispiel 25

10 g vorverlängertes Bisphenol-A-Bisphenol-A-diglycidylätherharz mit einem Epoxidgehalt von 0,629 Aeg./kg, 2,0 g 3,3', 4,4'-Benzophenontetracarbonsäuredianhydrid und 0,69 g Kupfer(II) acetat werden in 20 ml N-Methylpyrrolidon gelöst. Mit einem Rollercoater wird ein 50 µm dicker Nassfilm hergestellt, der eine Stunde bei 120 °C getrocknet wird. Nach dem Belichten mit einem Stufenkeil der oben beschriebenen Art bei 90 °C während 300 Sekunden und anschliessender stromloser Metallabscheidung gemäss Beispielen 1-10 erhält man als letzte abgebildete Stufe die Stufe Nr. 3.

Die in den obigen Beispielen 10 und 9-14 verwendeten neuen Thioxanthonderivate können wie folgt hergestellt werden :

i) Thioxanthon-3,4-dicarbonsäure-di-n-butylester

40,0 g 3-Nitrophthalimid und 49,5 g Thiosalicylsäure-Dinatriumsalz [hergestellt durch Lösen von Thiosalicylsäure in 2 Aequivalenten 1 N Natriumhydroxidlösung und Eindampfen, am Schluss zweimal mit Xylol] werden in 200 ml N,N-Dimethylformamid (DMF) während 8 Stunden bei 80 °C gerührt. Das Gemisch wird am Rotationsverdampfer bei 70 °C eingedampft und der Rückstand wird abfiltriert, mit Wasser gewaschen und getrocknet. Nach dem Umkristallisieren aus Dioxan erhält man 50,2 g (81 % d. Th.) 3-(2-Carboxyphenylthio)-phthalimid ; Smp. 289-290 °C.

20,0 g (66,8 mMol) 3-(2-Carboxyphenylthio)-phthalimid werden in 130 g Polyphosphorsäure suspendiert und während 90 min bei 150 °C gerührt. Das Reaktionsgemisch wird abgekühlt, vorsichtig mit 500 ml Wasser verrührt, und der Niederschlag wird abfiltriert und mehrmals mit Wasser gewaschen. Nach dem Trocknen im Vakuumtrockenschrank bei 150 °C wird aus Xylol umkristallisiert. Man erhält 12,4 g (66 % d. Th.) Thioxanthon-3,4-dicarbonsäureimid ; Smp. 348-350 °C.

4,80 g (17,1 mMol) Thioxanthon-3,4-dicarbonsäureimid werden in 511 ml 0,1 N NaOH-Lösung während 90 Min. am Rückfluss gehalten. Das entstandene Gemisch aus Amido- und Dicarbonsäure-Natriumsalzen wird mit konz. Salzsäure angesäuert und 18 Stunden am Rückfluss gehalten. Die rohe Thioxanthon-3,4-dicarbonsäure wird abfiltriert, mit Wasser gewaschen und in Xylol mit 11 ml Acetanhydrid durch Kochen am Rückfluss ins Anhydrid übergeführt, das nach teilweisem Eindampfen der Lösung ausfällt. Man erhält 4,32 g (90 % d. Th.) Thioxanthon-3,4-dicarbonsäure-anhydrid ; Smp. 330-331 °C.

2,9 g (10,3 mMol) Thioxanthon-3,4-dicarbonsäureanhydrid, 58 ml n-Butanol, 15 ml Toluol und 0,87 ml konz. Schwefelsäure werden 20 Stunden am Wasserabscheider gekocht. Das Gemisch wird teilweise eingedampft, und der Rückstand wird in Wasser/Methylenchlorid aufgenommen. Die organischen Extrakte werden mit Sole gewaschen, über Natriumsulfat getrocknet und eingedampft. Der Rückstand wird im Hochvakuum bei 150 °C getrocknet, wobei 3,92 g (92 % d. Th.) Thioxanthon-3,4-dicarbonsäure-di-n-butylester vom Smp. 49-51 °C erhalten werden.

Analyse für $C_{23}H_{24}O_5S$ (Molgewicht 412,50) :
berechnet C 66,97 H 5,86 0 19,39 S 7,77 %
gefunden C 67,10 H 5,88 0 19,14 S 7,63 %.

ii) Thioxanthon-3,4-dicarbonsäure-bis-[2-(2-methoxyäthoxy) äthyl] ester

1 g (3,5 mMol) Thioxanthon-3,4-dicarbonsäureanhydrid, 5 ml Diäthylenglykolmonomethyläther und 5 Tropfen konz. Schwefelsäure werden wie in Beispiel i) beschrieben umgesetzt und das Produkt isoliert, Man erhält 863 mg (48 % d. Th.) Thioxanthon-3,4-dicarbonsäure-bis-[2-(2-methoxyäthoxy) äthyl] ester (flüssig ; kristallisiert nach einigen Wochen zum Teil).

Analyse für $C_{25}H_{28}O_9S$ (Molgewicht 504,55) :
berechnet C 59,51 H 5,59 %
gefunden C 59,30 H 5,50 %.

iii) Thioxanthon-3,4-dicarbonsäure-N-(2-äthyl-n-hexyl) imid

2 g (7,1 mMol) Thioxanthon-3,4-dicarbonsäureanhydrid, 0,92 g (7,1 mMol) 2-Aethyl-1-hexylamin und 20 ml Xylol werden 30 Min. unter Wasserabscheidung am Rückfluss gehalten. Beim Abkühlen fallen 2,35 g (85 % d. Th.) Thioxanthon-3,4-dicarbonsäure-N-(2-äthyl-n-hexyl)imid aus ; Smp. 189-190 °C.

Analyse für $C_{23}H_{23}NO_3S$ (Molgewicht 393,50) :
berechnet C 70,20 H 5,89 N 3,56 S 8,15 %
gefunden C 70,05 H 5,57 N 3,54 S 8,17 %.

iv) Thioxanthon-3,4-dicarbonsäure-N-n-octylimid

4,0 g (14,2 mMol) Thioxanthon-3,4-dicarbonsäureimid, 4,12 g (21,3 mMol) 1-Octylbromid, 5,89 g (42,7 mMol) Kaliumcarbonat und 40 ml DMF werden 1 Tag bei 80 °C gerührt. Das Gemisch wird eingedampft, der Rückstand wird in 2N Salzsäure aufgenommen und mit Methylenchlorid extrahiert. Die organischen Phasen werden mit gesättigter $NaHCO_2$— und gesättigter NaCl-Lösung gewaschen, getrocknet und eingedampft. Nach dem Umkristallisieren aus Cyclohexan erhält man 5,28 g (95 % d. Th.) Thioxanthon-3,4-dicarbonsäure-N-n-octylimid ; Smp. 188-190 °C.

Analyse für $C_{23}H_{23}NO_3S$ (Molgewicht 393,50) :
berechnet C 70,20 H 5,89 N 3,56 O 12,20 S 8,15 %
gefunden C 70,05 H 5,86 N 3,71 O 12,77 S 8,11 %.

v) 3-Phenylsulfonylthioxanthon-1-carbonsäure-(2-methacryloyloxy)äthylester

0,62 g (1,8 mMol) 3-Nitrothioxanthon-1-carbonsäure-(2-hydroxyäthyl) ester, 0,44 g (2,7 mMol) Natriumbenzolsulfinat und 6 ml N,N-Dimethylformamid werden während 3 Stunden bei 100 °C gerührt. Das Gemisch wird eingedampft, der Rückstand wird in Tetrahydrofuran/Toluol aufgenommen, und die organische Phase wird mit $NaHCO_3$-Lösung gewaschen, über Natriumsulfat getrocknet und eingedampft. Aus Tetrahydrofuran/Toluol umkristallisiert erhält man 0,69 g (87 % d. Th.) Produkt ; Smp. 231-3 °C.

5,43 g (12,3 mMol) 3-Phenylsulfonylthioxanthon-1-carbonsäure-(2-hydroxyäthyl) ester, 3,87 g (37 mMol) frisch destilliertes Methacrylsäurechlorid, 70 ml Dioxan und 1 ml Pyridin werden während 10 Stunden bei 80 °C gerührt. Das Gemisch wird im Vakuum bei maximal 50 °C eingedampft. Der Rückstand wird in $CH_2Cl_2$ aufgenommen und mit Wasser von pH 6 gewaschen. Nach dem Trocknen der organischen Phase über Natriumsulfat wird eingedampft und aus Toluol umkristallisiert. Ausbeute 5,02 g (80 % d. Th.) ; Smp. 150-1 °C.

Der 3-Nitrothioxanthon-1-carbonsäure-(2-hydroxyäthyl)-ester kann wie folgt hergestellt werden :

6,02 g (20 mMol) 3-Nitrothioxanthon-1-carbonsäure, 60 ml Aethylenglykol und 2 Tropfen konz. Schwefelsäure werden 3 Stunden am Rückfluss gehalten. Das Gemisch wird abgekühlt, auf Wasser ausgetragen, auf pH 7 gestellt und der Niederschlag wird abfiltriert und getrocknet. Der Niederschlag wird kann in Methylenchlorid gelöst, die Lösung über Natriumsulfat getrocknet und eingedampft. Der Rückstand wird über Kieselgel mit 10 % Aceton/90 % $CH_2Cl_2$ chromatographiert. Zuerst werden 2,15 g (31 % d. Th.) 3-Nitrothioxanthon-1-carbonsäure-(2-hydroxyäthyl)-ester eluiert ; Smp. 201-3 °C. Anschliessend werden 2,33 g (30 % d. Th. 3-Nitrothioxanthon-1-carbonsäure-[2-(2-hydroxyäthyl)-äthyl]-ester erhalten ; Smp. 151-4 °C.

## Patentansprüche

1. Verwendung von lichtempfindlichen Stoffgemischen für die stromlose Metallabscheidung, enthaltend

a) 0,1 bis 20 Gewichtsprozent einer Verbindung der Formel I

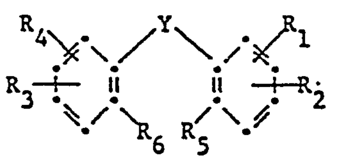

(I)

worin

$R_1$, $R_2$, $R_3$ und $R_4$ unabhängig voneinander ein Wasserstoff- oder Halogenatom, $C_{1-20}$-Alkyl, $-OR_7$, $-N(R_7)_2$, $-SR_7'$, $-NO_2$, $-SO_2R_7'$, $-COR_7$, $-COOR_7$, $-CON(R_7)_2$, $C_{1-4}$-Halogenalkyl, $C_{1-4}$-Hydroxyalkyl, $-O-C_dH_{2d}-COOH$, $-O[CH_2CH(X)O]_n-X$,

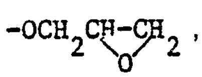

$-OCO-C(X)=CH_2$, $-CO-O[CH_2CH(X)O]_n-X$,

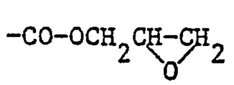

oder $-N(R_7)$ $(CO-C(X)=CH_2)$ oder $R_1$ und $R_2$ und/oder $R_3$ und $R_4$ zusammen $-CO-O-CO-$ oder $-CO-N(R_7)-CO-$,

$R_5$ und $R_6$ je Wasserstoff oder zusammen die direkte Bindung, $-CH_2-$, $-CH_2CH_2-$, $-CH=CH-$, $-S-$, $-O-$, $-CO-$ oder $-NH-$ und

$R_7$ Wasserstoff, $C_{1-20}$-Alkyl, $C_{1-6}$-Hydroxyalkyl, Allyl, Propargyl, $-C_dH_{2d}-OCO-C(X)=CH_2$, Phenyl, Alkylphenyl mit 1-4 C-Atomen im Alkyl, Benzyl, Phenyläthyl oder Cyclohexyl bedeuten,

$R_7'$ dieselbe Bedeutung wie $R_7$ hat, aber ungleich Wasserstoff ist,

n eine Zahl von 1-50, d eine Zahl von 1-4,

X Wasserstoff oder Methyl und

Y $-CO-$ oder $-CO-CO-$ darstellen,

b) 70 bis 99,8 Gewichtsprozent eines Polymeren mit H-Donorgruppen und einem durchschnittlichen Molekulargewicht von mindestens 2 000 Dalton oder eines Polymergemisches, das aus mindestens einer Polymerkomponente mit H-Donorgruppen und einem durchschnittlichen Molekulargewicht von mindestens 2 000 Dalton und mindestens einer zweiten Polymerkomponente mit einem durchschnittlichen Molekulargewicht von mindestens 2 000 Dalton besteht, und

c) 0,1 bis 10 Gewichtsprozent eines oder mehrerer Salze eines Metalls der Gruppe Ib oder VIII des Periodischen Systems, wobei sich die Gewichtsprozente auf die Summe von a + b + c beziehen und sich

die Komponenten a, b und c zusammen auf 100 Gewichtsprozent ergänzen und das Polymer b) teilweise mit den Metallsalzen c) komplexiert sein kann.

2. Verwendung nach Anspruch 1, wobei das Stoffgemisch eine Verbindung der Formel I enthält, worin

$R_3$ und $R_4$ Wasserstoff sind, $R_1$ ein Halogenatom, besonders Chlor oder Brom, $C_{1-4}$-Alkyl, —$SR_7'$, —$COOR_7$, —$CON(R_7)_2$, Chlor- oder Bromalkyl mit 1 oder 2 C-Atomen, —CO—$O[CH_2CH(X)O]_n$—X oder

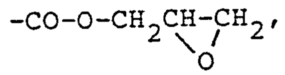

$R_2$ Wasserstoff, $C_{1-4}$-Alkyl, $C_{1-3}$-Alkoxy, —$COOR_7$, Phenylsulfonyl, —$NO_2$, —$O[CH_2CH(X)O]_n$—X, —CO-$O[CH_2CH(X)O]_n$—X oder

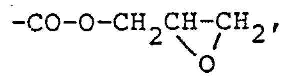

oder

$R_1$ und $R_2$ in ortho-Stellung zueinander gebunden sind und zusammen —CO—O—CO— oder —CO—$N(R_7)$—CO— darstellen,

$R_5$ und $R_6$ je Wasserstoff oder zusammen —$CH_2$—, —S—, —O—, —CO— oder —NH— und

$R_7$ $C_{1-10}$-Alkyl, $C_{1-4}$-Hydroxyalkyl, $C_{1-4}$-Alkyl—OCO—$C(X)=CH_2$, Cyclohexyl oder Allyl darstellen,

$R_7'$ dieselbe Bedeutung wie $R_7$ hat, aber ungleich Wasserstoff ist,

n eine Zahl von 1-10,

X Wasserstoff oder Methyl und

Y —CO— bedeuten.

3. Verwendung nach Anspruch 1, wobei das Stoffgemisch 4 bis 7 Gewichtsprozent einer Verbindung der Formel I, worin

$R_1$ in 2-Stellung gebunden ist und —COO—$C_{1-6}$-Alkyl, besonders —COO-n-Butyl, oder

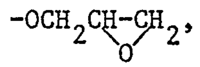

$R_2$, $R_3$ und $R_4$ Wasserstoff, $R_5$ und $R_6$ zusammen —CO— und

Y —CO— darstellen,

sowie 87 bis 93 Gewichtsprozent der Komponente b) und 3 bis 6 Gewichtsprozent der Komponente c) enthält.

4. Verwendung nach Anspruch 1, wobei das Stoffgemisch 4 bis 7 Gewichtsprozent einer Verbindung der Formel I, worin $R_3$ und $R_4$ Wasserstoff sind, $R_1$ und $R_2$ in 1-, 2- und/oder 3-Stellung gebunden sind und $R_1$ —COO—$C_{1-6}$-Alkyl und $R_2$ Wasserstoff, Phenylsulfonyl oder —$NO_2$ bedeuten, oder $R_1$ und $R_2$ in 3,4-Stellung gebunden sind und je —COO—$C_{1-6}$-Alkyl oder —$COO(CH_2CH_2O)_n$—$CH_3$ mit n = 2 oder 3 oder zusammen —CO—$N(R_7)$—CO— darstellen, wobei $R_7$ $C_{2-8}$-Alkyl oder Allyl ist, $R_5$ und $R_6$ zusammen —S— und Y —CO— bedeuten, sowie 87 bis 93 Gewichtsprozent der Komponente b) und 3 bis 6 Gewichtsprozent der Komponente c) enthält.

5. Verwendung nach Anspruch 1, wobei das Stoffgemisch 4 bis 7 Gewichtsprozent einer Verbindung der Formel I, worin $R_1$ in 1-Stellung gebunden ist und —COO—$C_{1-6}$-Alkyl, besonders —COO-n-Butyl bedeutet, $R_2$ in 3-Stellung gebunden ist und Wasserstoff, —$NO_2$ oder Phenylsulfonyl darstellt oder $R_1$ und $R_2$ in 3,4 Stellung gebunden sind und je —COO—$C_{1-6}$-Alkyl oder —$COO(CH_2CH_2O)_2CH_3$ oder zusammen —CO—$N(C_{2-8}$-Alkyl)—CO— darstellen, $R_3$ und $R_4$ Wasserstoff, $R_5$ und $R_6$ zusammen —S— und Y —CO— bedeuten, sowie 87 bis 93 Gewichtsprozent der Komponente b) und 3 bis 6 Gewichtsprozent der Komponente c) enthält.

6. Verwendung nach Anspruch 1, wobei das Stoffgemisch ein Polymeres enthält, das aus gleichen oder verschiedenen wiederkehrenden Strukturelementen der Formel

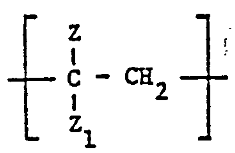

(II)

besteht, worin

Z Wasserstoff, Chlor oder Methyl,

$Z_1$ Wasserstoff, Chlor, Methyl, —OH, —CN, —COOH, —$CONH_2$, Phenyl, Methylphenyl, Methoxyphenyl, Cyclohexenyl, Imidazolyl, Pyrrolidonyl, —COO-Alkyl mit 1-12 C-Atomen im Alkyl, —COOPhenyl,

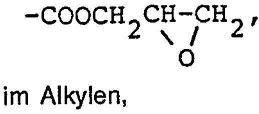

—COO-Alkylen—OH mit 2-12 C-Atomen im Alkylen,

$-COO(CH_2CH_2O)_p-H$ oder $-COO[CH_2CH(CH_3)O]_p-H$ mit $p = 2$-4, —OCOAlkyl mit 1-4 C-Atomen im Alkyl, —OCOPhenyl, —COAlkyl mit 1-4 C-Atomen im Alkyl, $C_{1-12}$-Alkoxy, Phenoxy, Hydroxymethylphenyl, —CONH—$C_{1-4}$-Alkylen—OH, —COO—$C_{1-4}$-Alkylen—N(Q') (Q") oder $-OCO(CH_2)_x-OH$ mit $x = 2$-5, Q' Wasserstoff oder $C_{1-5}$-Alkyl und Q" $C_{1-5}$-Alkyl darstellen, wobei $Z_1$ in mindestens 20 % der Strukturelemente der Formel II —OH, —COO—$C_{2-12}$-Alkylen—OH, $-COO(CH_2CH_2O)_p-H$, $-COO[CH_2CH(CH_3)O]_p-H$, $-OCO(CH_2)_x-OH$ mit $x = 2$-5, Hydroxymethylphenyl, —CONH—$C_{1-4}$-Alkylen—OH oder —COO—$C_{1-4}$-Alkylen—N—(Q') (Q") bedeutet.

7. Verwendung nach Anspruch 6, worin Z Wasserstoff oder Methyl und $Z_1$ Methyl, Phenyl, Methylphenyl, —COO—$C_{1-10}$-Alkyl, —COO—$C_{2-12}$-Alkylen—OH, Hydroxymethylphenyl oder —COO—$C_{1-4}$-Alkylen—$N(CH_3)_2$ darstellen, wobei der Anteil an Gruppen —COO—$C_{2-12}$-Alkylen—OH, Hydroxymethylphenyl oder —COO—$C_{1-4}$-Alkylen—$N(CH_3)_2$ 20 bis 70 % beträgt.

8. Verwendung nach Anspruch 6, worin in 55-65 % der Strukturelemente Z Wasserstoff und besonders Methyl und $Z_1$ $-COO(CH_2)_2N(CH_3)_2$ und vor allem $-COO(CH_2)_2OH$, $-COOCH_2CH(CH_3)OH$ oder $-COO(CH_2)_3OH$ und in 35-45 % der Strukturelemente Z Wasserstoff oder Methyl und $Z_1$ Phenyl oder —COO—$C_{1-8}$-Alkyl, besonders —COOMethyl, —COOAethyl oder —COO-2-Aethylhexyl bedeuten.

9. Verwendung nach Anspruch 1, wobei das Stoffgemisch ein Polykondensations- oder Polyadditionsprodukt enthält, das gleiche oder verschiedene Strukturelemente der Formeln III, IV, V oder VI

$$-[NH-A-NH-CO-A_1CO]- \quad (III)$$
$$-[CH_2CH(OH)CH_2-O-A_2-O]-[CH_2CH(OH)CH_2-A_3]_{y-1} \quad (IV)$$
oder
$$-[CH_2CH(OH)CH_2-\overset{|}{N}-A-\overset{|}{N}]- \quad (V)$$
$$-[CH_2CH(OH)CH_2-OCO-A_1-COO]- \quad (VI)$$

und gegebenenfalls Strukturelemente der Formel VII

$$-[CO-A_1-CO-O-A_4-O]- \quad (VII)$$

aufweist, worin y die Zahl 1 oder 2,

A $-C_mH_{2m}-$ mit m = 2-12, Cyclohexylen, Naphthylen, gegebenenfalls durch eine Methyl-, Methoxy- oder Nitrogruppe substituiertes Phenylen, 1,3- oder 1,4-Xylylen, den Rest des 4,4'-Diaminodicyclohexylmethans, 4,4'-Diaminodiphenylmethans, 4,4'-Diaminodiphenyläthers, 4,4'-Diaminodiphenylsulfons oder Isophorondiamins,

$A_1$ die direkte Bindung, $-C_mH_{2m}$ mit m = 2-12, Cyclohexylen, Cyclohexenylen, Endomethylencyclohexenylen oder Phenylen, die durch $-CH_3$ substituiert sein können,

$A_2$ $-C_mH_{2m}-$ mit m = 2-12, Phenylen,

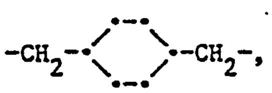, 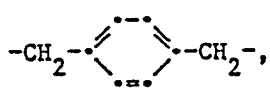,

eine Gruppe der Formeln

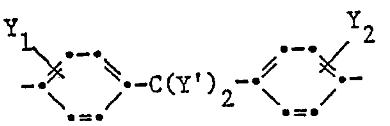 oder $-(Y_3O)_{\overline{o}}Y_3-$,

Y' Wasserstoff oder Methyl,

$Y_1$ und $Y_2$ unabhängig voneinander Wasserstoff, Chlor oder Brom,

$Y_3$ $-(CH_2)_2-$, $-CH_2CH(CH_3)-$ oder $-(CH_2)_4-$,

o eine Zahl von 1-50,

$A_3$

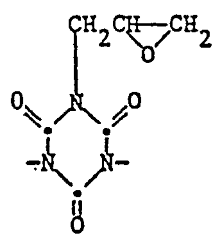, 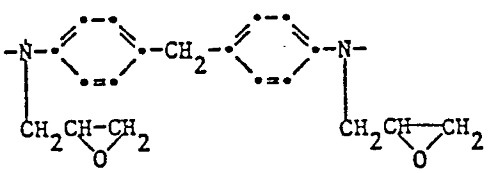,

den Rest des Aethylenharnstoffs, Propylenharnstoffs, 5,5-Dimethylhydantoins, 2-Hydroxyäthyl- oder 2-Hydroxypropyl-5,5-dimethylhydantoins und

$A_4$ $-C_mH_{2m}-$ mit m = 2-12, $-(CH_2CH_2O)_rCH_2CH_2-$ mit r = 1-40, $-CH(CH_3)CH_2OCH_2CH(CH_3)-$, Cyclohexylen, $-CH_2-C(CH_3)_2-CH_2OCO-C(CH_3)_2-CH_2-$,

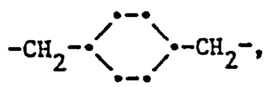, 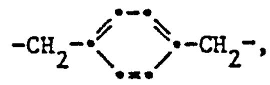, 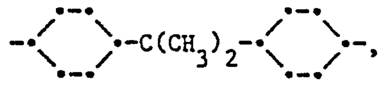,

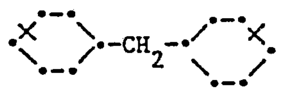 ,

Naphthylen, Biphenylen oder gegebenenfalls durch eine Methyl-, Methoxy- oder Nitrogruppe substituiertes Phenylen darstellen.

10. Verwendung nach Anspruch 9, enthaltend ein Additionsprodukt aus Diolen $HO-A_4-OH$, Dicarbonsäuren $HOOC-A_1-COOH$, Carbonsäure-Endgruppen enthaltenden Oligoestern der Formel VIII

$$HO-[CO-A_1-CO-O-A-O]_s-CO-A_1-COOH \quad \text{(VIII)}$$

und/oder Diaminen $H_2N-A-NH_2$ mit Diglycidylverbindungen der Formel IX

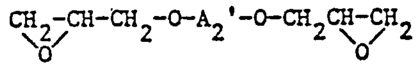 (IX)

worin

A $-(CH_2)_m-$ mit m = 4-10, den Rest des 4,4'-Diaminodiphenylmethans, 4,4'-Diaminodiphenyläthers oder Isophorondiamins,

$A_1$ $-(CH_2)_m-$ mit m = 2-10, 1,3- oder 1,4-Phenylen, 1,3- oder 1,4-Cyclohexylen,

s eine Zahl von 1-100, besonders 1-20,

$A_2'$ $-C_mH_{2m}-$ mit m = 2, 4 oder 6, eine Gruppe der Formeln

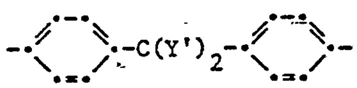 , $-(CH_2CH_2O)_o-CH_2CH_2-$

und/oder $-(CH_2CH_2O)_o-CH_2CH_2-$ und/oder $-[CH_2CH(CH_3)O]_o-CH_2CH(CH_3)-$ mit Y' = H und vor allem Methyl und o = 1-40, vor allem 2-20, oder ein Oligomeres der Formel X

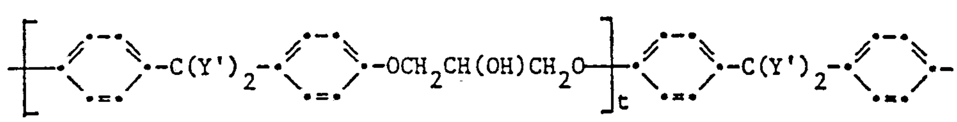 (X)

mit t = 1,2 bis 12 und Y' = H und insbesondere Methyl und

$A_4$ $-C_mH_{2m}-$ mit m = 2-12, $-(CH_2CH_2O)_r-CH_2CH_2-$ mit r = 1-40, besonders 1-20, $-CH(CH_3)CH_2OCH_2CH(CH_3)-$, 1,2-Cyclohexylen, 2,2'-Biphenylen oder 1,3-Phenylen bedeuten.

11. Verwendung nach Anspruch 9, enthaltend ein Additionsprodukt aus Diolen der Formel XI

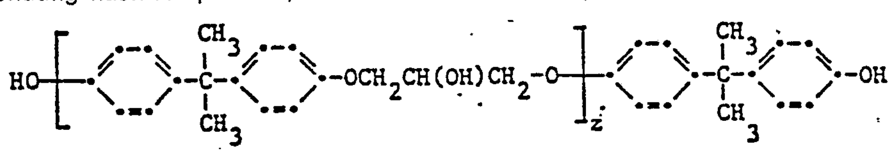 (XI)

und Diglycidylverbindungen der Formeln XII oder XIII

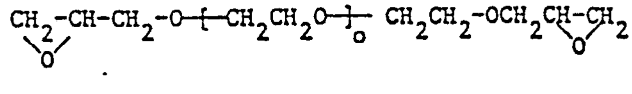 (XII)

oder

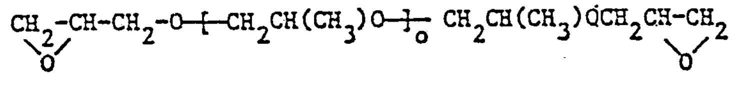 (XIII)

worin z eine Zahl von 1-8 und o eine Zahl von 1-10 bedeuten.

12. Verwendung nach Anspruch 1, worin das Metallsalz ein Kupfer(II) carboxylat, besonders Kupfer(II) acetat, gegebenenfalls im Gemisch mit einem Kupfer(II) halogenid, vor allem Kupfer(II) bromid ist.

13. Verwendung nach Anspruch 1, worin das Stoffgemisch zusätzlich ein Lösungsmittel und/oder ein Vernetzungsmittel enthält.

## Claims

1. Use of a photosensitive composition for metal deposition without current, which composition contains

a) 0.1 to 20 per cent by weight of a compound of the formula I

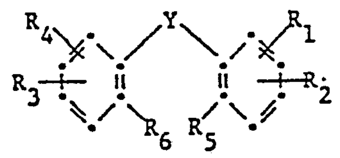 (I)

in which

$R_1$, $R_2$, $R_3$ and $R_4$ are each independently a hydrogen or halogen atom, $C_{1-20}$ alkyl, $—OR_7$, $—N(R_7)_2$, $—SR_7'$, $—NO_2$, $—SO_2R_7'$, $—COR_7$, $—COOR_7$, $—CON(R_7)_2$, $C_{1-4}$ haloalkyl, $C_{1-4}$ hydroxyalkyl, $—O—C_dH_{2d}—COOH$, $—O[CH_2CH(X)O]_n—X$,

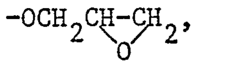

$—OCO—C(X)=CH_2$, $—CO—O[CH_2CH(X)O]_n—X$,

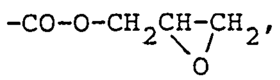

or $—N(R_7)(CO—C(X)=CH_2)$ or $R_1$ and $R_2$ and/or $R_3$ and $R_4$ together are $—CO—O—CO—$ or $—CO—N(R_7)—CO—$,

$R_5$ and $R_6$ are each hydrogen or together are a direct bond, $—CH_2—$, $—CH_2CH_2—$, $—CH=CH—$, $—S—$, $—O—$, $—CO—$ or $—NH—$,

$R_7$ is hydrogen, $C_{1-20}$-alkyl, $C_{1-6}$ hydroxyalkyl, allyl, propargyl, $—C_dH_{2d}—OCO—C(X)=CH_2$, phenyl, alkylphenyl having 1-4 C atoms in the alkyl moiety, benzyl, phenethyl or cyclohexyl,

$R_7'$ has the same meaning as $R_7$, with the exception of hydrogen,

n is a number from 1 to 50, d is a number from 1 to 4,

X is hydrogen or methyl and

Y is $—CO—$ or $—CO—CO—$,

b) 70 to 99.8 per cent by weight of a polymer with H donor groups and an average molecular weight of at least 2,000 Daltons, or of a polymer mixture which consists of at least one polymer component with H donor groups and an average molecular weight of at least 2,000 Daltons and at least one second polymer component with an average molecular weight of at least 2,000 Daltons, and

c) 0.1 to 10 per cent by weight of one or more salts of a metal of group Ib or VIII of the periodic table, and the percentages by weight are based on the sum of a + b + c and components a, b and c together make up 100 per cent by weight, and the polymer b) may be partly complexed with the metal salts c).

2. Use according to claim 1, wherein the composition contains a compound of the formula I in which

$R_3$ and $R_4$ are hydrogen, $R_1$ is a halogen atom, in particular chlorine or bromine, $C_{1-4}$-alkyl, $—SR_7'$, $—COOR_7$, $—CON(R_7)_2$, chloro- or bromoalkyl having 1 or 2 C atoms, $—CO—O[CH_2CH(X)O]_n—X$ or

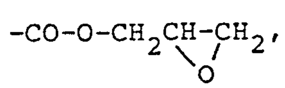

and $R_2$ is hydrogen, $C_{1-4}$-alkyl, $C_{1-3}$-alkoxy, $—COOR_7$, phenylsulfonyl, $—NO_2$, $—O[CH_2CH(X)O]_n—X$, $—CO—O[CH_2CH(X)O]_n—X$ or

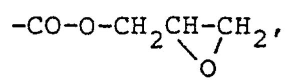

or $R_1$ and $R_2$ are bonded in the ortho-position relative to each other and together are $—CO—O—CO—$ or $—CO—N(R_7)—CO$,

$R_5$ and $R_6$ are each hydrogen or together are $—CH_2—$, $—S—$, $—O—$, $—CO—$ or $—NH—$,

$R_7$ is $C_{1-10}$-alkyl, $C_{1-4}$-hydroxyalkyl, $C_{1-4}$-alkyl$—OCO—C(X)=CH_2$, cyclohexyl or allyl,

$R_7'$ has the same meaning as $R_7$, with the exception of hydrogen,

n is a number from 1 to 10,

X is hydrogen or methyl
and Y is —CO—.

3. Use according to claim 1, wherein the composition contains 4 to 7 per cent by weight of a compound of the formula I in which

$R_1$ is bonded in the 2-position and is —COO—$C_{1-6}$-alkyl, in particular —COO-n-butyl, or

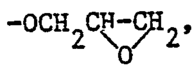

$R_2$, $R_3$ and $R_4$ are hydrogen, $R_5$ and $R_6$ together are —CO—
and Y is —CO—,
and 87 to 93 per cent by weight of component b) and 3 to 6 per cent by weight of component c).

4. Use according to claim 1, wherein the composition contains 4 to 7 per cent by weight of a compound of the formula I in which $R_3$ and $R_4$ are hydrogen, $R_1$ and $R_2$ are bonded in the 1-, 2- and/or 3-position and $R_1$ is —COO—$C_{1-6}$-alkyl and $R_2$ is hydrogen, phenylsulfonyl or —$NO_2$, or $R_1$ and $R_2$ are bonded in the 3,4-position and each is —COO—$C_{1-6}$-alkyl or —COO($CH_2CH_2O$)$_n$—$CH_3$, where n = 2 or 3, or together are —CO—N($R_7$)—CO—, in which $R_7$ is $C_{2-8}$-alkyl or allyl, $R_5$ and $R_6$ together are —S— and Y is —CO—, and 87 to 93 per cent by weight of component b) and 3 to 6 per cent by weight of component c).

5. Use according to claim 1, wherein the composition contains 4 to 7 % by weight of a compound of the formula I, in which $R_1$ is bonded in the 1-position and is —COO—$C_{1-6}$ alkyl, in particular —COO-n-butyl, and $R_2$ is bonded in the 3-position and is hydrogen, —$NO_2$ or phenylsulfonyl, or $R_1$ and $R_2$ are bonded in the 3,4-position and each is —COO—$C_{1-6}$ alkyl or —COO($CH_2CH_2O$)$_2$$CH_3$ or together are —CO—N($C_{2-8}$ alkyl)—CO—, $R_3$ and $R_4$ are hydrogen, $R_5$ and $R_6$ together are —S— and Y is —CO—, and 87 to 93 % by weight of component b) and 3 to 6 % by weight of component c).

6. Use according to claim 1, wherein the composition contains a polymer consisting of identical or different recurring structural elements of the formula

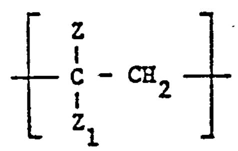

(II)

in which

Z is hydrogen, chlorine or methyl and

$Z_1$ is hydrogen, chlorine, methyl, —OH, —CH, —COOH, —$CONH_2$, phenyl, methylphenyl, methoxyphenyl, cyclohexenyl, imidazolyl, pyrrolidonyl, —COO-alkyl having 1-12 C atoms in the alkyl moiety, —COOphenyl,

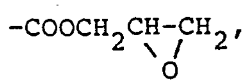

—COO-alkylene—OH having 2-12 C atoms in the alkylene moiety, —COO($CH_2CH_2O$)$_p$—H or —COO[$CH_2CH(CH_3)O$]$_p$—H where p = 2-4, —OCOalkyl having 1-4 C atoms in the alkyl moiety, —OCOphenyl, —COalkyl having 1-4 C atoms in the alkyl moiety, $C_{1-12}$ alkoxy, phenoxy, hydroxymethylphenyl, —CONH— $C_{1-4}$ alkylene—OH, —COO—$C_{1-4}$alkylene—N(Q') (Q'') or —OCO($CH_2$)$_x$—OH, where x = 2-5, and Q' is hydrogen or $C_{1-15}$ alkyl and Q'' is $C_{1-5}$ alkyl, and $Z_1$ in at least 20 % of the structural elements of the formula II is OH, —COO—$C_{2-12}$ alkylene—OH, —COO($CH_2CH_2O$)$_p$—H, —COO[$CH_2CH(CH_3)O$]$_p$—H, —OCO($CH_2$)$_x$—OH, where x = 2-5, hydroxymethylphenyl, —CONH—$C_{1-4}$ alkylene—OH or —COO—$C_{1-4}$ alkylene—N—(Q') (Q''). alkylene—N—(Q') (Q'').

7. Use according to claim 6, wherein Z is hydrogen or methyl and $Z_1$ is methyl, phenyl, methylphenyl, —COO—$C_{1-10}$ alkyl, —COO—$C_{2-12}$ alkylene—OH, hydroxymethylphenyl or —COO—$C_{1-4}$ alkylene—N($CH_3$)$_2$, the proportion of —COO—$C_{1-12}$ alkylene—OH, hydroxymethylphenyl or —COO—$C_{1-4}$ alkylene—N($CH_3$)$_2$ groups being 20 to 70 %.

8. Use according to claim 6, in which, in 55-65 % of the structural elements, Z is hydrogen or, in particular, methyl and $Z_1$ is —COO($CH_2$)$_2$N($CH_3$)$_2$ or, in particular, —COO($CH_2$)$_2$OH, —$COOCH_2CH(CH_3)OH$ or —COO($CH_2$)$_3$OH, and, in 35-45 % of the structural elements, Z is hydrogen or methyl and $Z_1$ is phenyl or —COO—$C_{1-8}$ alkyl, in particular —COO methyl, —COO ethyl or —COO-2-ethylhexyl.

9. Use according to claim 1, wherein the composition contains a polycondensation or polyaddition product which contains identical or different structural elements of the formula III, IV, V or VI

$$-[NH-A-NH-CO-A_1CO]- \qquad (III)$$

$$-[CH_2CH(OH)CH_2-O-A_2-O]-[CH_2CH(OH)CH_2-A_3]_{y-1}- \qquad (IV)$$

-[ $CH_2CH(OH)CH_2$-N-A-N] - or (V)

-[ $CH_2CH(OH)CH_2$-OCO-$A_1$-COO] - (VI)

and, optionally, structural elements of the formula VII

$$—[CO—A_1—CO—O—A_4—O]— \quad (VII)$$

in which y is the number 1 or 2,

A is $—C_mH_{2m}—$, where m = 2-12, cyclohexylene, naphthylene, phenylene which is unsubstituted or substituted by a methyl, methoxy or nitro group, or is 1,3- or 1,4-xylylene or the radical of 4,4'-diaminodicyclohexylmethane, 4,4'-diaminodiphenylmethane, 4,4'-diaminodiphenyl ether, 4,4'-diaminodiphenyl sulfone or isophoronediamine,

$A_1$ is a direct bond, $—C_mH_{2m}—$, where m = 2-12, or cyclohexylene, cyclohexenylene, endomethylenecyclohexenylene or phenylene, each of which can be substituted by $—CH_3$,

$A_2$ is $—C_mH_{2m}—$, where m = 2-12, phenylene,

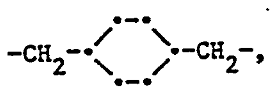, 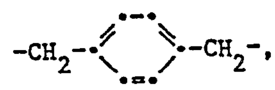,

or a group of the formula

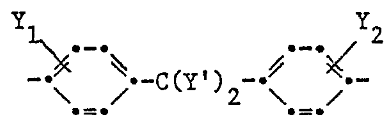 or $-(Y_3O)_o-Y_3$,

Y' is hydrogen or methyl,

$Y_1$ and $Y_2$ are each independently hydrogen, chlorine or bromine,

$Y_3$ is $—(CH_2)_2—$, $—CH_2CH(CH_3)—$ or $—(CH_2)_4—$,

o is a number from 1 to 50,

$A_3$ is

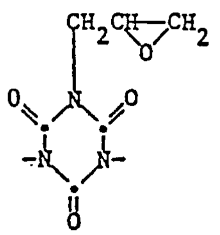, 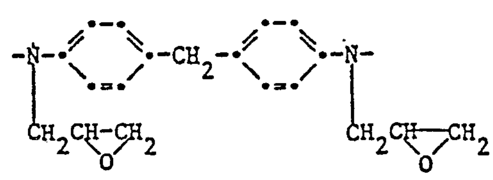,

or the radical of ethylene-urea, propylene-urea, 5,5-dimethylhydantoin or 2-hydroxyethyl- or 2-hydroxypropyl-5,5-dimethylhydantoin and

$A_4$ is $—C_mH_{2m}—$, where m = 2-12, $—(CH_2CH_2O)_rCH_2CH_2—$, where r = 1-40, $—CH(CH_3)CH_2OCH_2CH(CH_3)—$, cyclohexylene, $—CH_2—C(CH_3)_2—CH_2OCO—C(CH_3)_2—CH_2—$,

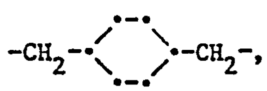, 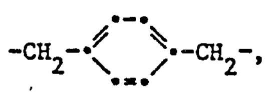, 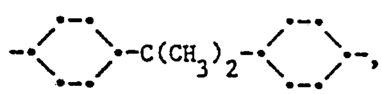,

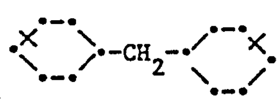,

naphthylene, biphenylene, or phenylene which is unsubstituted or substituted by a methyl, methoxy or nitro group.

10. Use according to claim 9, in which the composition contains an addition product of diols $HO—A_4—OH$, dicarboxylic acids $HOOC—A_1—COOH$, oligoesters, containing carboxylic acid end groups, of the formula VIII

$$HO—[CO—A_1—CO—O—A_4—O]_s—CO—A_1—COOH \quad (VIII)$$

and/or diamines $H_2N—A—NH_2$ with diglycidyl compounds of the formula IX

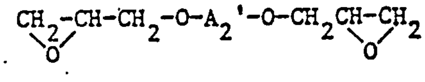 (IX)

in which

A is $-(CH_2)_m-$, where m = 4-10, or the radical of 4,4'-diaminodiphenylmethane, 4,4'-diaminodiphenyl ether or isophoronediamine,

$A_1$ is $-(CH_2)_m-$, where m = 2-10, 1,3- or 1,4-phenylene or 1,3- or 1,4-cyclohexylene,

s is a number from 1 to 100, in particular 1 to 20,

and $A_2'$ is $-C_mH_{2m}-$, where m = 2, 4 or 6, or a group of the formula

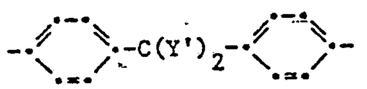 , $-(CH_2CH_2O)_o-CH_2CH_2-$

and/or $-(CH_2CH_2O)_o-CH_2CH_2-$ and/or $-[CH_2CH(CH_3)O]_o-CH_2CH(CH_3)-$, where Y' = H or, in particular, methyl and o = 1-40, in particular 2-20, or an oligomer of the formula X

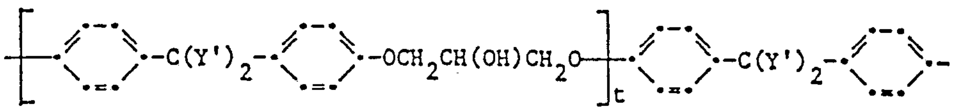 (X)

where t = 1.2 to 12 and Y' = H or, in particular, methyl, and $A_4$ is $-C_mH_{2m}-$, where m = 2-12, $-(CH_2CH_2O)_r-CH_2CH_2-$, where r = 1-40, in particular 1-20, $-CH(CH_3)CH_2OCH_2CH(CH_3)-$, 1,2-cyclohexylene, 2,2'-biphenylene or 1,3-phenylene.

11. Use according to claim 9, wherein the composition contains an addition product of diols of the formula XI

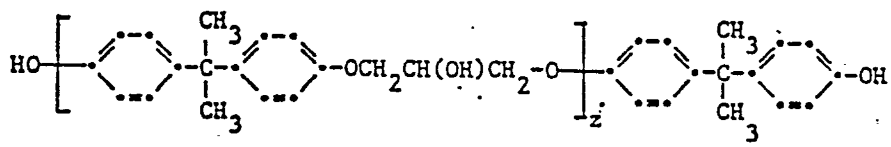 (XI)

and diglycidyl compounds of the formula XII or XIII

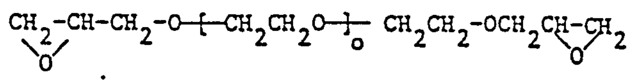 (XII)

or

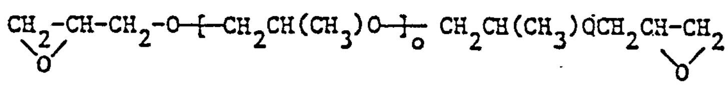 (XIII)

in which z is a number from 1 to 8 and o is a number from 1 to 10.

12. Use according to claim 1, wherein the metal salt is a copper (II) carboxylate, in particular copper (II) acetate, by itself or in admixture with a copper (II) halide, in particular copper (II) bromide.

13. Use according to claim 1, wherein the composition additionally contains a solvent and/or a crosslinking agent.

**Revendications**

1. Utilisation de mélanges de substances photosensibles pour la déposition de métaux non électrolytique, contenant

a) 0,1 à 20 % en poids d'un composé de formule I

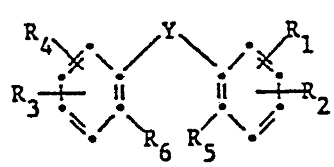 (I)

dans laquelle

$R_1$, $R_2$, $R_3$ et $R_4$, indépendamment les uns des autres, sont chacun un atome d'hydrogène ou d'halogène, un radical alkyle en $C_{1-20}$, $-OR_7$, $-N(R_7)_2$, $-SR'_7$, $-NO_2$, $-SO_2R_7'$, $-COR_7$, $-COOR_7$, $-CON(R_7)_2$, halogénalkyle en $C_{1-4}$, hydroxyalkyle en $C_{1-4}$, $-O-C_dH_{2d}-COOH$, $-O[CH_2CH(X)O]_n-X$,

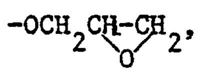

—OCO—C(X)=$CH_2$, —CO—O[$CH_2CH(X)O$]$_n$—X,

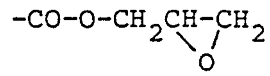

ou —N($R_7$)(CO—C(X)=$CH_2$) ou bien $R_1$ et $R_2$ et/ou $R_3$ et $R_4$ forment ensemble —CO—O—CO— ou —CO—N($R_7$)—CO—,

$R_5$ et $R_6$ sont chacun l'hydrogène ou forment ensemble une liaison directe, —$CH_2$—, —$CH_2CH_2$—, —CH=CH—, —S—, —O—, —CO— ou —NH—, et

$R_7$ est l'hydrogène, un radical alkyle en $C_{1-20}$, hydroxyalkyle en $C_{1-6}$, allyle, propargyle, —$C_dH_{2d}$—OCO—C(X)=$CH_2$, phényle, alkylphényle avec 1 à 4 atomes de carbone dans le fragment alkyle, benzyle, phényléthyle ou cyclohexyle,

$R_7'$ a la même signification que $R_7$ mais est différent de l'hydrogène,

n est un nombre de 1 à 50, d est un nombre de 1 à 4,

X est l'hydrogène ou le radical méthyle, et

Y est —CO— ou —CO—CO—,

b) 70 à 99,8 % en poids d'un polymère ayant des groupes donneurs H et une masse moléculaire moyenne d'au moins 2 000 Daltons ou d'un mélange de polymères qui est constitué d'au moins un constituant polymère possédant des groupes donneurs H et ayant une masse moléculaire moyenne d'au moins 2 000 Daltons et d'au moins un deuxième constituant polymère ayant une masse moléculaire moyenne d'au moins 2 000 Daltons, et

c) 0,1 à 10 % en poids d'un ou plusieurs sels d'un métal du Groupe Ib ou VIII du Tableau Périodique, les pourcentages en poids se rapportant à la somme a + b + c et les constituants a, b et c faisant en tout 100 % en poids, et le polymère b) pouvant être partiellement complexé par les sels métalliques c).

2. Utilisation selon la revendication 1, le mélange de substances contenant un composé de formule I, dans laquelle

$R_3$ et $R_4$ sont l'hydrogène, $R_1$ est un atome d'halogène, en particulier le chlore ou le brome, un radical alkyle en $C_{1-4}$, —$SR_7'$, —$COOR_7$, —CON$(R_7)_2$, chloralkyle ou bromalkyle ayant 1 ou 2 atomes de carbone, —CO—O[$CH_2CH(X)O$]$_n$—X ou

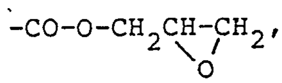

$R_2$ est l'hydrogène, un radical alkyle en $C_{1-4}$, alcoxy en $C_{1-3}$, —$COOR_7$, phénylsulfonyle, —$NO_2$, —O-[$CH_2CH(X)O$]$_n$—X, —CO—O[$CH_2CH(X)O$]$_n$—X ou

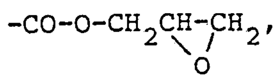

ou bien

$R_1$ et $R_2$ sont liés l'un à l'autre en position ortho et forment ensemble —CO—O—CO— ou —CO—N($R_7$)—CO—,

$R_5$ et $R_6$ sont chacun l'hydrogène ou forment ensemble —$CH_2$—, —S—, —O—, —CO— ou —NH—, et

$R_7$ est un radical alkyle en $C_{1-10}$, hydroxyalkyle en $C_{1-4}$, (alkyle en $C_{1-4}$)—OCO—C(X)=$CH_2$, cyclohexyle ou allyle,

$R_7'$ a la même signification que $R_7$ mais est différent de l'hydrogène,

n est un nombre de 1 à 10,

X est l'hydrogène ou le radical méthyle et

Y est —CO—.

3. Utilisation selon la revendication 1, le mélange de substances contenant 4 à 7 % en poids d'un composé de formule I, dans laquelle

$R_1$ est lié en position 2 et représente —COO-(alkyle en $C_{1-6}$), en particulier —COO-n-butyle, ou

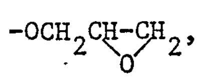

$R_2$, $R_3$ et $R_4$ sont chacun l'hydrogène, $R_5$ et $R_6$ forment ensemble —CO—, et

Y représente —CO—,

ainsi que 87 à 93 % en poids du constituant b) et 3 à 6 % en poids du constituant c).

4. Utilisation selon la revendication 1, où le mélange de substances contient 4 à 7 % en poids d'un composé de formule I dans laquelle $R_3$ et $R_4$ sont chacun l'hydrogène, $R_1$ et $R_2$ sont liés en position 1, 2 ou 3 et $R_1$ est un radical —COO-(alkyle en $C_{1-6}$) et $R_2$ est l'hydrogène, un radical phénylsulfonyle ou —$NO_2$, ou bien $R_1$ et $R_2$ sont liés en position 3,4 et sont chacun un radical —COO-(alkyle en $C_{1-6}$) ou —COO$(CH_2CH_2O)_n$—$CH_3$ avec n = 2 ou 3, ou forment ensemble le radical —CO—N($R_7$)—CO—, où $R_7$ est un radical alkyle en $C_{2-8}$ ou allyle, $R_5$ et $R_6$ forment —S— et Y est —CO—, ainsi que 87 à 93 % en poids du constituant b) et 3 à 6 % en poids du constituant c).

5. Utilisation selon la revendication 1, où le mélange de substances contient 4 à 7 % en poids d'un composé de formule I, dans laquelle $R_1$ est lié en position 1 et est un radical —COO-(alkyle en $C_{1-6}$), en particulier —COO-n-butyle, $R_2$ est lié en position 3 et est l'hydrogène, $—NO_2$ ou le radical phénylsulfonyle, ou bien $R_1$ et $R_2$ sont liés en position 3,4 et sont chacun un radical —COO-(alkyle en $C_{1-6}$) ou $—COO(CH_2CH_2O)CH_3$ ou forment ensemble —CO—N(alkyle en $C_{2-8}$)—CO—, $R_3$ et $R_4$ sont l'hydrogène, $R_5$ et $R_6$ forment ensemble —S— et Y est —CO—, ainsi que 87 à 93 % en poids du constituant b) et 3 à 6 % en poids du constituant c).

6. Utilisation selon la revendication 1, où le mélange de substances contient un polymère qui est constitué de motifs structuraux répétitifs identiques ou différents de formule

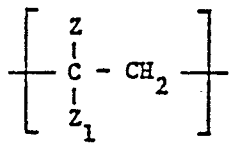

(II)

dans laquelle

Z est l'hydrogène, le chlore ou le radical méthyle,

$Z_1$ est l'hydrogène, le chlore, le radical méthyle, —OH, —CN, —COOH, $—CONH_2$, phényle, méthylphényle, méthoxyphényle, cyclohexyle, imidazolyle, pyrrolidonyle, —COO-alkyle avec 1 à 12 atomes de carbone dans le fragment alkyle, —COO-phényle,

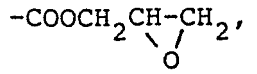

—COO-alkylène—CH avec 2 à 12 atomes de carbone dans le fragment alkylène, $—COO(CH_2CH_2O)_p—H$ ou $—COO[CH_2CH(CH_3)O]_p—H$ avec p = 2 à 4, —OCO-alkyle avec 1 à 4 atomes de carbone dans le fragment alkyle, —OCO-phényle, —CO-alkyle avec 1 à 4 atomes de carbone dans le fragment alkyle, alcoxy en $C_{1-12}$, phénoxy, hydroxyméthylphényle, —CONH-(alkylène en $C_{1-4}$)—OH, —COO-(alkylène en $C_{1-4}$)—N(Q')(Q") ou $—OCO(CH_2)_x—OH$ avec x = 2 à 5, Q' est l'hydrogène ou un radical alkyle en $C_{1-5}$ et Q" est un radical alkyle en $C_{1-5}$, où $Z_1$, dans au moins 20 % des motifs structuraux de formule II, est —OH, —COO-(alkylène en $C_{2-12}$)—OH, $—COO(CH_2CH_2O)_p—H$, $—COO[CH_2CH(CH_3)O]_p—H$, $—OCO(CH_2)_x—OH$ avec x = 2 à 5, hydroxyméthylphényle, —CONH-(alkylène en $C_{1-4}$)—OH ou —COO-(alkylène en $C_{1-4}$)—N—(Q')(Q").

7. Utilisation selon la revendication 6, dans laquelle Z est l'hydrogène ou le radical méthyle et $Z_1$ est le radical méthyle, phényle, méthylphényle, —COO-(alkyle en $C_{1-10}$), —COO-(alkylène en $C_{2-12}$)—OH, hydroxyméthylphényle ou —COO(alkylène en $C_{1-4}$)—$N(CH_3)_2$, où le pourcentage de groupes —COO-(alkylène en $C_{2-12}$)—OH, hydroxyméthylphényle ou —COO-(alkylène en $C_{1-4}$)—$N(CH_3)_2$ est de 20 à 70 %.

8. Utilisation selon la revendication 6, dans laquelle Z, dans 55-65 % des motifs structuraux, est l'hydrogène et en particulier le radical méthyle et $Z_1$ est $—COO(CH_2)_2N(CH_3)_2$ et surtout $—COO(CH_2)_2OH$, $—COOCH_2CH(CH_3)OH$ ou $—COO(CH_2)_3OH$ et, dans 35-45 % des motifs structuraux, Z est l'hydrogène ou le radical méthyle et Z est le radical phényle ou —COO-(alkyle en $C_{1-8}$), en particulier —COO-méthyle, —COO-éthyle ou —COO-(éthyl-2 hexyle).

9. Utilisation selon la revendication 1, dans laquelle le mélange de substances est un produit de polycondensation ou de polyaddition, qui possède des motifs structuraux identiques ou différents de formules III, IV, V ou VI :

$-[NH-A-NH-CO-A_1CO]-$ (III)

$-[CH_2CH(OH)CH_2-O-A_2-O]-[CH_2CH(OH)CH_2-A_3]_{y-1}-$ (IV)

$-[CH_2CH(OH)CH_2-N-A-N]-$ ou (V)

$-[CH_2CH(OH)CH_2-OCO-A_1-COO]-$ (VI)

et éventuellement des motifs structuraux de formule VII

$—[CO—A_1—CO—O—A_4—O]—$ (VII)

dans lesquelles y est le nombre 1 ou 2,

A est $—C_mH_{2m}—$ avec m = 2 à 12, un radical cyclohexylène, naphtylène, phénylène éventuellement substitué par un groupe méthyle, méthoxy ou nitro, xylylène-1,3 ou -1,4, le résidu du diamino-4,4' dicyclohexylméthane, du diamino-4,4' diphénylméthane, de l'oxyde de diamino-4,4' diphényle, de la diamino-4,4' diphénylsulfone ou de l'isophoronediamine,

$A_2$ est $—C_mH_{2m}—$ avec m = 2 à 12, un radical phénylène,

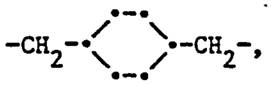 , 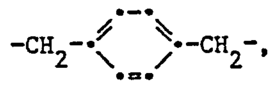 ,

un groupe de formules

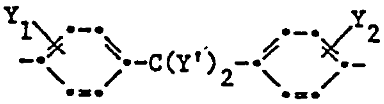

ou $—(Y_3O)_o—H_3—$,

Y′ est l'hydrogène ou le radical méthyle,

$Y_1$ et $Y_2$, indépendamment l'un de l'autre, sont chacun l'hydrogène, le chlore ou le brome,

$Y_3$ est $—(CH_2)_2$, $—CH_2CH(CH_3)—$ ou $(CH_2)_4—$,

o est un nombre de 1 à 50,

$A_3$ est

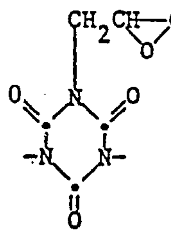 , 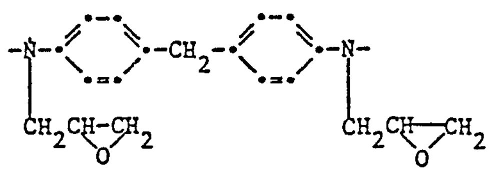 ,

le résidu de l'éthylène-urée, de la propylène-urée, de la diméthyl-5,5 hydantoïne, de l'hydroxyéthyl-2 ou hydroxypropyl-2 diméthyl-5,5 hydantoïne, et

$A_4$ est $—C_mH_{2m}—$ avec m = 2 à 12, $—(CH_2CH_2O)_rCH_2CH_2—$ avec r = 1 à 40, $—CH(CH_3)CH_2O$-$CH_2CH(CH_3)—$, cyclohexylène, $—CH_2—C(CH_3)_2—CH_2OCO—C(CH_3)_2—CH_2—$,

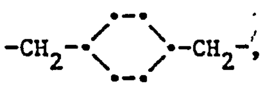 , 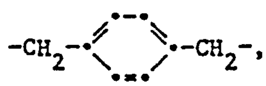 , 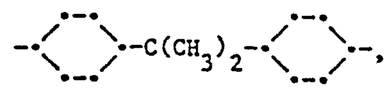 ,

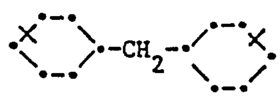 ,

naphtylène, biphénylène ou phénylène éventuellement substitué par un groupe méthyle, méthoxy ou nitro.

10. Utilisation selon la revendication 9, contenant un produit d'addition de diols $HO—A_4—OH$, acides dicarboxyliques $HOOC—A_1—COOH$, oligoesters de formule VIII contenant des groupes terminaux carboxyliques

$$HO—[CO—A_1—CO—O—A_4—O]_s—CO—A_1—COOH \qquad (VIII)$$

et/ou diamines $H_2N—A—NH_2$, avec des composés diglycidyliques de formule IX

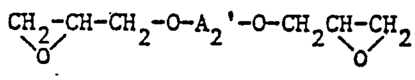 (IX)

dans lesquelles

A est $—(CH_2)_m—$ avec m = 4 à 10, le résidu du diamino-4,4′ diphénylméthane, de l'oxyde de diamino-4,4′ diphényle ou de l'isophoronediamine,

$A_1$ est $—(CH_2)_m—$ avec m = 2 à 10, un radical phénylène-1,3 ou -1,4, cyclohexylène-1,3 ou -1,4.

s est un nombre de 1 à 100, en particulier de 1 à 20,

$A_2'$ est $—C_mH_{2m}—$ avec m = 2, 4 ou 6, un groupe de formules

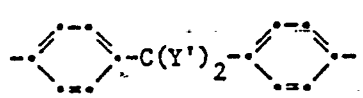 , $—(CH_2CH_2O)_o—CH_2CH_2—$,

et/ou $—[CH_2CH(CH_3)O]_o—CH_2CH(CH_3)—$ avec Y′ = H et surtout un radical méthyle et o = 1 à 40, surtout 2 à 20, ou un oligomère de formule X

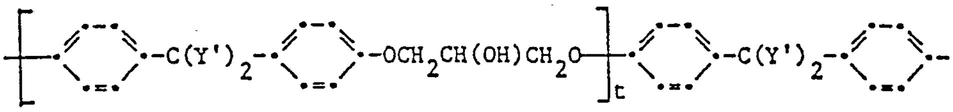 (X)

avec t = 1,2 à 12 et Y' = H et en particulier le radical méthyle, et

$A_4$ est $—C_mH_{2m}—$ avec m = 2 à 12, $—(CH_2CH_2O)_r—CH_2CH_2—$ avec r = 1 à 40, en particulier 1 à 20, $—CH(CH_3)CH_2OCH_2CH(CH_3)$, cyclohexylène-1,2, biphénylène-2,2' ou phénylène-1,3.

11. Utilisation selon la revendication 9, contenant un produit d'addition de diols de formule XI

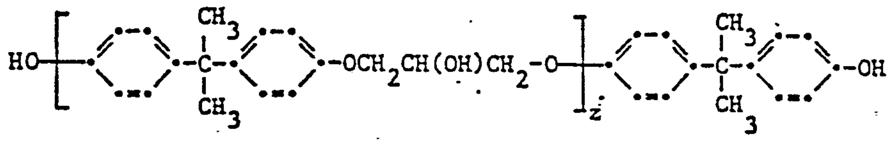 (XI)

et de composés diglycidyliques de formyles XII ou XIII

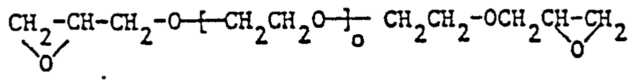 (XII)

ou

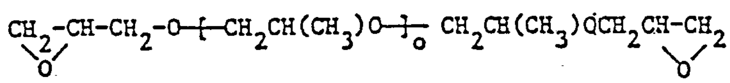 (XIII)

dans lesquelles z est un nombre de 1 à 8 et o est un nombre de 1 à 10.

12. Utilisation selon la revendication 1, dans laquelle le sel métallique est un carboxylate de cuivre (II), en particulier l'acétate de cuivre (II), éventuellement en mélange avec un halogénure de cuivre (II), surtout le bromure de cuivre (II).

13. Utilisation selon la revendication 1, dans laquelle le mélange de substances contient en outre un solvant et/ou un agent de réticulation.